# EUROPEAN PATENT APPLICATION

(11) **EP 4 787 038 A1**
(43) Date of publication of application: **05.08.2026**
(21) Application number: 25211730.4
(22) Date of filing: 28.10.2025
(51) Int. Cl.: G02B 6/42, H05K 1/14, H10W 40/20, H10W 90/20

(54) **SEMICONDUCTOR DEVICE**

(30) Priority: 03.02.2025 US 202519043562
(71) Applicant: MEDIATEK INC., Hsinchu City 30078 (TW)
(72) Inventor: Yang, Yu-Tao, San Jose, CA (US); Hung, Chih-Ming, San Jose, CA (US)
(74) Representative: Bandpay & Greuter

(57) **Abstract**

A semiconductor device is provided. The semiconductor device includes a first circuit board, a first semiconductor chip assembly, a first cooling unit and a first supporting component. The first circuit board has a first surface. The first semiconductor chip assembly is disposed on the first surface of the first circuit board. The first supporting component connects the first cooling unit with the first circuit board in a thickness direction of the semiconductor device.

## Description

The invention relates to a semiconductor device.

### BACKGROUND OF THE INVENTION

Conventional semiconductor device includes a circuit board and a plurality of chips, wherein the chips are disposed on a surface of the circuit board. As the computing speed becomes faster and faster, the number of the chips becomes more and more, and accordingly the circuit board is required to have larger area of the surface. However, the larger the size of the circuit board is, the less the manufacturing yield of the circuit board is. Thus, how to resolve the conventional problem has become a prominent task for the industries.

### SUMMARY OF THE INVENTION

In an embodiment of the invention, a semiconductor device is provided. The semiconductor device includes a first circuit board, a first semiconductor chip assembly, a first cooling unit and a first supporting component. The first circuit board has a first surface. The first semiconductor chip assembly is disposed on the first surface of the first circuit board. The first supporting component connects the first cooling unit with the first circuit board in a thickness direction of the semiconductor device.

In another embodiment of the invention, a manufacturing method for a semiconductor device is provided. The manufacturing method includes the following steps: disposing a first semiconductor chip assembly on a first surface of a first circuit board; and disposing a first supporting component to connect the first cooling unit with the first circuit board in a thickness direction of the semiconductor device.

Numerous objects, features and advantages of the invention will be readily apparent upon a reading of the following detailed description of embodiments of the invention when taken in conjunction with the accompanying drawings. However, the drawings employed herein are for the purpose of descriptions and should not be regarded as limiting.

### BRIEF DESCRIPTION OF THE DRAWINGS

The above objects and advantages of the invention will become more readily apparent to those ordinarily skilled in the art after reviewing the following detailed description and accompanying drawings, in which:
FIG. 1A illustrates a schematic diagram of a top view of a semiconductor device according to an embodiment of the invention;
FIG. 1B illustrates a schematic diagram of a cross-sectional view of the semiconductor device in FIG. 1A along a direction 1B-1B';
FIG. 2A illustrates a schematic diagram of a top view of a semiconductor device according to another embodiment of the invention;
FIG. 2B illustrates a schematic diagram of a cross-sectional view of the semiconductor device in FIG. 2A along a direction 2B-2B';
FIG. 3A illustrates a schematic diagram of a top view of a semiconductor device according to another embodiment of the invention;
FIG. 3B illustrates a cross-sectional view of the semiconductor device in FIG. 3A along a direction 3B-3B';
FIG. 4A illustrates a schematic diagram of a top view of a semiconductor device according to another embodiment of the invention;
FIG. 4B illustrates a cross-sectional view of the semiconductor device in FIG. 4A along a direction 4B-4B';
FIGS. 5A to 5H illustrate schematic diagrams of manufacturing processes of the semiconductor device in FIG. 1B;
FIGS. 6A to 6F illustrate schematic diagrams of manufacturing processes of the semiconductor device in FIG. 2B;
FIGS. 7A to 7G illustrate schematic diagrams of manufacturing processes of the semiconductor device 300 in FIG. 3B;
FIGS. 8A to 8E illustrate schematic diagrams of manufacturing processes of the semiconductor device in FIG. 4B;
FIG. 9 illustrates a schematic diagram of a cross-sectional view of a semiconductor device according to another embodiment of the invention; and
FIGS. 10A to 10B illustrate schematic diagrams of manufacturing processes of the semiconductor device in FIG. 9.

### DETAILED DESCRIPTION OF PREFERRED EMBODIMENTS

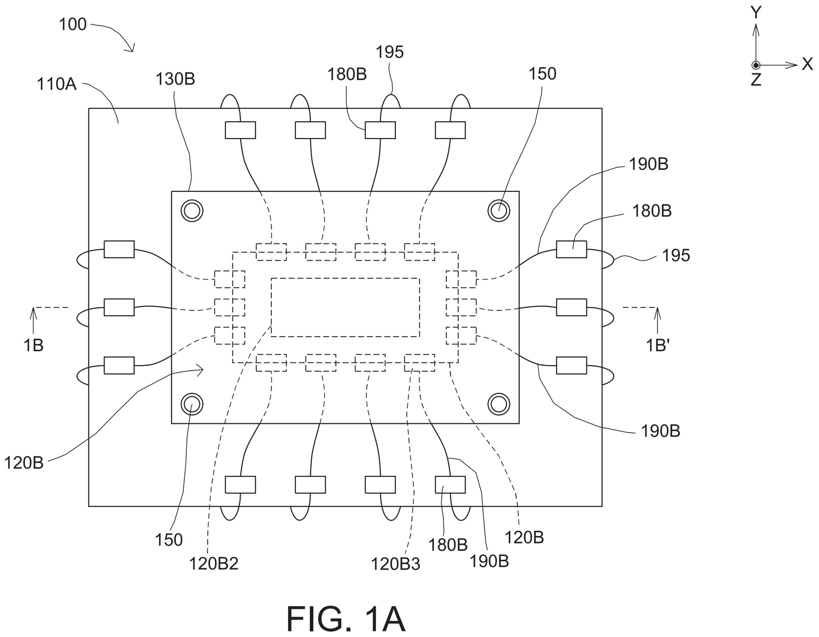

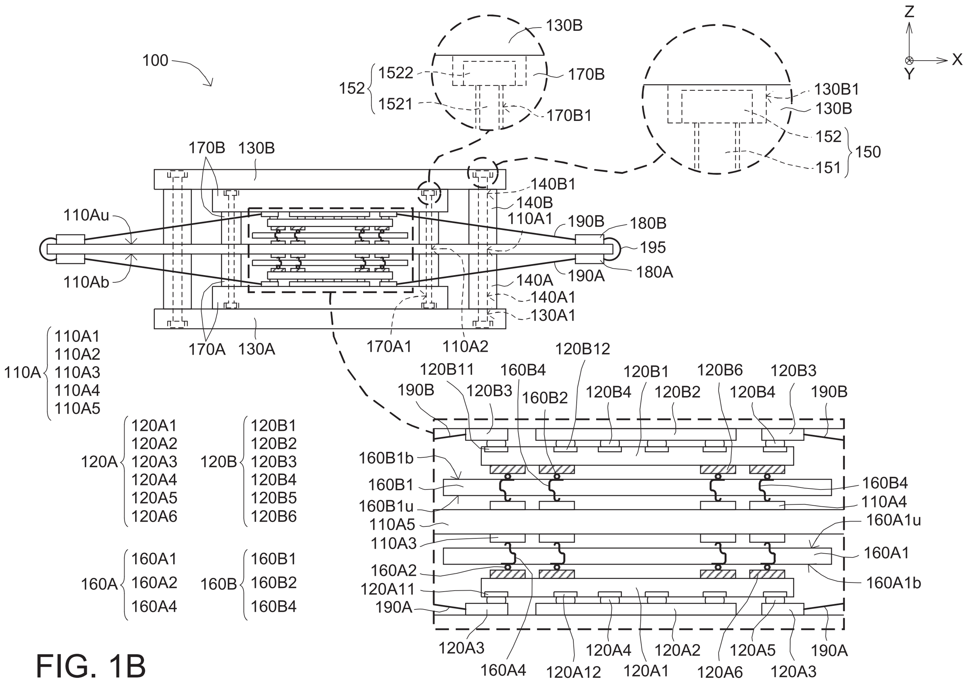

Referring to FIGS. 1A to 1B, FIG. 1A illustrates a schematic diagram of a top view of a semiconductor device 100 according to an embodiment of the invention, and FIG. 1B illustrates a schematic diagram of a cross-sectional view of the semiconductor device 100 in FIG. 1A along a direction 1B-1B'.

As illustrated in FIGS. 1A and 1B, the semiconductor device 100 includes a first circuit board 110A, a first semiconductor chip assembly 120A, a second semiconductor chip assembly 120B, a first cooling unit 130A, a second cooling unit 130B, a first supporting component 140A, a second supporting component 140B, at least one first fixing component 150, at least one second fixing component 152, a first socket 160A, a second socket 160B, a first compression component 170A, a second compression component 170B, at least one first optical fiber connector 180A, at least one second optical fiber connector 180B, at least one first optical fiber 190A, at least one second optical fiber 190B and at least one third optical fiber 195.

As illustrated in FIG. 1B, the first circuit board 110A has a first surface 110Ab and a second surface 110Au opposite to the first surface 110Ab. The first semiconductor chip assembly 120A is disposed on the first surface 110Ab of the first circuit board 110A. The first supporting component 140A connects the first cooling unit 130A with the first circuit board 110A. In the present embodiment, the first circuit board 110A and the first semiconductor chip assembly 120A are stacked to each other in a Z-axis (for example, a thickness direction of the semiconductor device 100), and it may reduce the area of the semiconductor device 100 in XY plane, and increase a manufacturing yield of the circuit board (due to the area of the circuit board may be reduced).

As illustrated in FIG. 1B, the first circuit board 110A is, for example, a printed circuit board (PCB). The first circuit board 110A has at least one first hole 110A1, at least one second hole 110A2, at least one first contact 110A3, at least one second contact 110A4 and a board body 110A5. The board body 110A5 has the first surface 110Ab and the second surface 110Au, wherein the first hole 110A1 and the second hole 110A2 extend to the second surface 110Au from the first surface 110Ab. The first contact 110A3 and the second contact 110A4 are disposed on the first surface 110Ab and the second surface 110Au respectively. The first contact 110A3 and the second contact 110A4 are electrically connected with each other through at least conductive structure (for example, redistribution layer (RDL), at least one trace, at least one pad, at least one via, etc.) in or on the board body 110A5.

As illustrated in FIG. 1B, the first semiconductor chip assembly 120A includes a first substrate 120A1, at least one first chip 120A2, at least one second chip 120A3, at least one first contact 120A4, at least one second contact 120A5 and at least one third contact 120A6. The first substrate 120A1 is, for example, a printed circuit board, an interposer, a portion of a silicon wafer, etc. The first chip 120A2 and the second chip 120A3 are disposed on a first surface 120A1b of the first substrate 120A1 side by side. The first chip 120A2 is, for example, an ASIC (Application-Specific Integrated Circuit), etc., and the second chip 120A3 is, for example, PIC (Photonic Integrated Circuit), etc. The PIC may be or include, for example, a bare silicon die or a packaged silicon die, wherein the packaged silicon die may be or include an optical engine (OE). The first contact 120A4 is disposed between the first substrate 120A1 and the first chip 120A2 and electrically connects the first substrate 120A1 with the first chip 120A2. The second contact 120A5 is disposed between the first substrate 120A1 and the second chip 120A3 and electrically connects the first substrate 120A1 with the second chip 120A3. The third contact 120A6 is disposed on a second surface 120A1u of the first substrate 120A1. The first contact 120A4, the second contact 120A5 and/or the third contact 120A6 is, for example, solder ball, bump, pillar, pad, etc.

As illustrated in FIG. 1B, the first substrate 120A1 of the first semiconductor chip assembly 120A incudes at least one first contact 120A11 and at least one second contact 120A12, wherein the first contact 120A11 is connected with the second chips 120A3 through the second contact 120A5, and the second contact 120A12 is connected with the first chip 120A2 through the second contact 120A5. In the present embodiment, the second contact 120A5 may be cured.

As illustrated in FIG. 1B, the second semiconductor chip assembly 120B and the first semiconductor chip assembly 120A are disposed on the two opposite sides of the first circuit board 110A. For example, the second semiconductor chip assembly 120B is disposed on the second surface 110Au of the first circuit board 110A. The second semiconductor chip assembly 120B includes a second substrate 120B1, at least one first chip 120B2, at least one second chip 120B3, at least one first contact 120B4, at least one second contact 120B5 and at least one third contact 120B6. The second substrate 120B1 is, for example, a printed circuit board, an interposer, a portion of a silicon wafer, etc. The first chip 120B2 and the second chip 120B3 are disposed on a first surface 120B1b of the second substrate 120B1 side by side. The first chip 120B2 is, for example, an ASIC, etc., and the second chip 120B3 is, for example, PIC, etc. The first contact 120B4 is disposed between the second substrate 120B1 and the first chip 120B2 and electrically connects the second substrate 120B1 with the first chip 120B2. The second contact 120B5 is disposed between the second substrate 120B1 and the second chip 120B3 and electrically connects the second substrate 120B1 with the second chip 120B3. The third contact 120B6 is disposed on a second surface 120B1u of the second substrate 120B1. The first contact 120B4, the second contact 120B5 and/or the third contact 120B6 is, for example, solder ball, bump, pillar, pad, etc.

As illustrated in FIG. 1B, the second substrate 120B1 of the second semiconductor chip assembly 120B incudes at least one first contact 120B11 and at least one second contact 120B12, wherein the second substrate 120B11 is connected with the second chips 120B3, and the second contact 120B12 is connected with the first chip 120B2.

As illustrated in FIG. 1B, the first cooling unit 130A is, for example, a cold plate. The second cooling unit 130B is, for example, a cold plate. The first cooling unit 130A has at least one hole 130A1, and the second cooling unit 130B has at least one hole 130B1. In an embodiment, the cooling unit may have a cooling channel, and a coolant (for example, gas or liquid) flows through cooling channel for dissipating the heat.

As illustrated in FIG. 1B, the second supporting component 140B and the first supporting component 140A are disposed on two opposite sides of the first circuit board 110A. For example, the first supporting component 140A connects the second cooling unit 130B with the first surface 110Ab of the first circuit board 110A, and the second supporting component 140B connects the second cooling unit 130B with the second surface 110Au of the first circuit board 110A. The first supporting component 140A has at least one hole 140A1, and the second supporting component 140B has at least one hole 140B1.

In an embodiment, the supporting component may have a cooling channel, and a coolant (for example, gas or liquid) flows through cooling channel for dissipating the heat. The cooling channel of the supporting component and the cooling channel of the cooling unit are communicated with each other or separated from each other.

As illustrated in FIG. 1B, the first fixing component 150 may fix a relative position among the first circuit board 110A, the first cooling unit 130A, the second cooling unit 130B, the first supporting component 140A and the second supporting component 140B.

For example, as illustrated in FIG. 1B, the first fixing component 150 includes a first fixing rod 151 and a first pressing portion 152, wherein the first fixing rod 151 passes through the hole 130A1 of the first cooling unit 130A, the hole 140A1 of the first supporting component 140A, the first hole 110A1 of the first circuit board 110A, and the hole 140B1 of the second supporting component 140B and the hole 130B1 of the second cooling unit 130B, and the first pressing portion 152 is combined to the first fixing rod 151 to fix the relative position among the first circuit board 110A, the first cooling unit 130A and the second cooling unit 130B, the first supporting component 140A and the second supporting component 140B. In an embodiment, the first fixing rod 151 is, for example, bolt, and the first pressing portion 152 is, for example, nut.

As illustrated in FIG. 1B, the first semiconductor chip assembly 120A may be disposed on the first circuit board 110A through the first socket 160A.

Furthermore, the first socket 160A is disposed between the first semiconductor chip assembly 120A and the first circuit board 110A. The first semiconductor chip assembly 120A is electrically connected with the first circuit board 110A through the first socket 160A. Furthermore, the first socket 160A incudes a socket body 160A1, at least one contact 160A2 and at least one conductive spring 160A4, wherein the socket body 160A1 has a first surface 160A1u and a second surface 160A1b opposite to the first surface 160A1u. The contact 160A2 is disposed on the second surface 160A1b and electrically connected with the conductive spring 160A4. The conductive spring160A4 is disposed in the socket body 160A1, and a portion of the conductive spring160A4 protrudes relative to the first surface 160A1u to contact with the first contact 110A3. The third contact 120A6 of the first semiconductor chip assembly 120A is in contact with the contact 160A2 of the first socket 160A, and electrically connected with the first circuit board 110A through the contact 160A2, the conductive spring 160A4 and the first contact 110A3. In the present embodiment, the contact 160A2 is, for example, solder bump. In another embodiment, the contact 160A2 is, for example, spring.

As illustrated in FIG. 1B, the second semiconductor chip assembly 120B may be disposed on the first circuit board 110A through the second socket 160B.

Furthermore, the second socket 160B is disposed between the second semiconductor chip assembly 120B and the first circuit board 110A. The second semiconductor chip assembly 120B is electrically connected with the first circuit board 110A through the second socket 160B. Furthermore, the second socket 160B incudes a socket body 160B1, at least one contact 160B2 and at least one conductive spring 160B4, wherein the socket body 160B1 has a first surface 160B1u and a second surface 160B1b opposite to the first surface 160B1u, the contact 160B2 is disposed on the second surface 160B1b, the conductive spring 160B4 connects the contact 160B2 and electrically connected with the contact 160B2. The third contact 120B6 of the second semiconductor chip assembly 120B is in contact with the contact 160B2 of the second socket 160B, and electrically connected with the first circuit board 110A through the contact 160B2, the conductive spring 160B4 and the second contact 110A4. In the present embodiment, the contact 160B2 is, for example, solder bump. In another embodiment, the contact 160B2 is, for example, spring.

As illustrated in FIG. 1B, the first compression component 170A may press against the first socket 160A and the first semiconductor chip assembly 120A on the first circuit board 110A. The second compression component 170B may press against the second socket 160B and the second semiconductor chip assembly 120B on the first circuit board 110A. The first compression component 170A has a hole 170A1, and the second compression component 170B has a hole 170B1. In addition, the first compression component 170A and the second compression component 170B are, for example, compression hardware, brackets, frames, etc.

As illustrated in FIG. 1B, the second fixing component 152 may fix a relative position among the first compression component 170A, the first circuit board 110A and the second compression component 170B.

As illustrated in FIG. 1B, the second fixing component 152 includes a second fixing rod 1521 and a second pressing portion 1522, wherein the second fixing rod 1521 passes through the hole 170A1 of the first compression component 170A, the second hole 110A2 of the first circuit board 110A and the hole 170B1 of the second compression component 170B, and the second pressing portion 1522 is combined to the second fixing rod 1521 to fix the relative position among the first circuit board 110A, the first compression component 170A and the second compression component 170B. In an embodiment, the second fixing rod 1521 is, for example, bolt, and the second pressing portion 1522 is, for example, nut.

As illustrated in FIG. 1B, the first optical fiber connectors 180A are disposed on the first surface 110Ab of the first circuit board 110A, and the first optical fibers 190A connect the first optical fiber connectors 180A with the second chips 120A3 of the first substrate 120A. The second optical fiber connectors 180B are disposed on the second surface 110Au of the first circuit board 110A, and the second optical fibers 190B connect the second optical fiber connectors 180B with the fourth chips 120B3 of the second substrate 120B.

As illustrated in FIG. 1B, the third optical fibers 195 connect the first optical fiber connector 180A with the second optical fiber connector 180B cross over a lateral surface of the first circuit board 110A. In another embodiment, the optical fiber 195 may be replaced by a soft ribbon bus, and the optical fiber connectors 180A and 180B may be replaced by bus connectors.

As described above, the first semiconductor chip assembly 120A and the second semiconductor chip assembly 120B may be electrically connected through one circuit board (for example, the first circuit board 110A) and at least one socket (for example, the first socket 160A and/or the second at least one 160B), and optically connected through the optical fiber (for example, the first optical fiber 190A, the second optical fiber 190B and/or the third optical fiber 195) and/or at least one connector (for example, the first optical fiber connector 180A and/or the second optical fiber connector 180B).

As described above, the first circuit board 110A, at least one semiconductor chip assembly (for example, the first semiconductor chip assembly 120A and/or the second semiconductor chip assembly 120B) and at least one socket (for example, the first socket 160A and/or the second socket 160B) are stacked to each other in a Z-axis (for example, a thickness direction of the semiconductor device 100), and it may reduce the area of the semiconductor device 100 in XY plane, and increase a manufacturing yield of the circuit board (due to the area of the circuit board may be reduced).

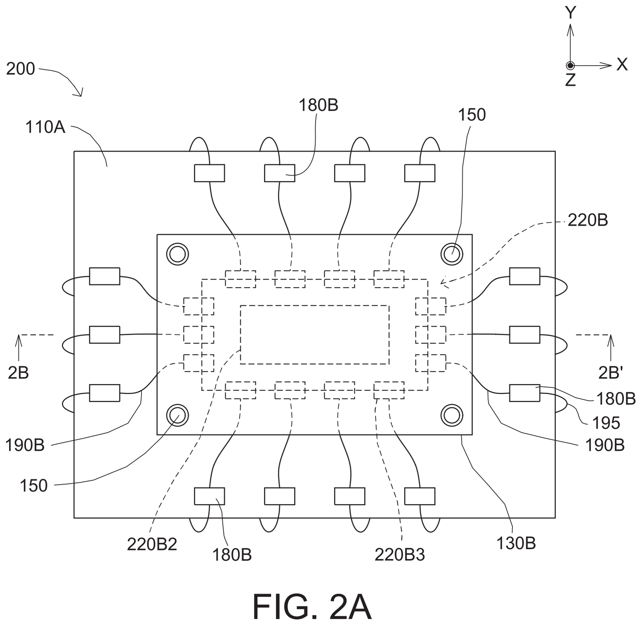

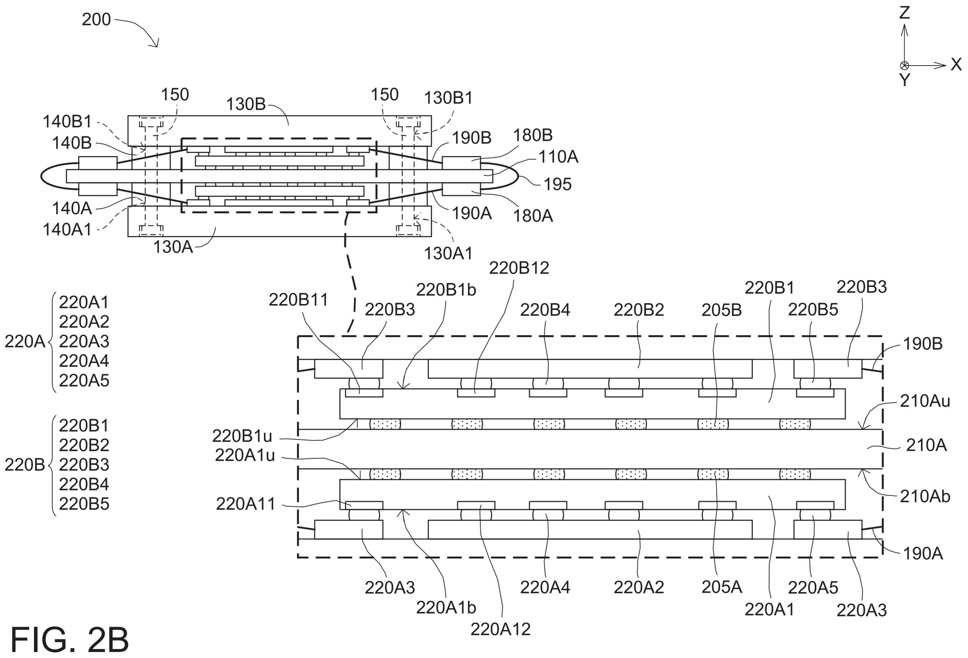

Referring to FIGS. 2A to 2B, FIG. 2A illustrates a schematic diagram of a top view of a semiconductor device 200 according to another embodiment of the invention, and FIG. 2B illustrates a schematic diagram of a cross-sectional view of the semiconductor device 200 in FIG. 2A along a direction 2B-2B'.

As illustrated in FIGS. 2A and 2B, the semiconductor device 200 includes a first circuit board 210A, the first semiconductor chip assembly 120A, the second semiconductor chip assembly 120B, the first cooling unit 130A, the second cooling unit 130B, the first supporting component 140A, the second supporting component 140B, at least one first fixing component 150, at least one second fixing component 152, at least one first optical fiber connector 180A, at least one second optical fiber connector 180B, at least one first optical fiber 190A, at least one second optical fiber 190B, at least one third optical fiber 195, at least one first contact 205A and at least one second contact 205B.

As illustrated in FIG. 2B, the first circuit board 210A has the first surface 210Ab and a second surface 210Au opposite to the first surface 210Ab. The first semiconductor chip assembly 220A is disposed on the first surface 210Ab of the first circuit board 210A. The first supporting component 140A connects the first cooling unit 130A with the first circuit board 210A. In the present embodiment, the first circuit board 210A and the first semiconductor chip assembly 220A are stacked to each other in a Z-axis (for example, a thickness direction of the semiconductor device 200), and it may reduce the area of the semiconductor device 200 in XY plane, and increase a manufacturing yield of the circuit board (due to the area of the circuit board may be reduced).

As illustrated in FIG. 2B, the first circuit board 210A is, for example, a PCB. The first circuit board 210A has at least one first hole 210A1.

As illustrated in FIG. 2B, the first semiconductor chip assembly 220A includes the first substrate 220A1, at least one first chip 220A2, at least one second chip 220A3, at least one first contact 220A4 and at least one second contact 220A5. The first chip 220A2 and the second chip 220A3 are disposed on the first surface 220A1b of the first substrate 220A1 side by side. The first contact 220A4 is disposed between the first substrate 220A1 and the first chip 220A2 and electrically connects the first substrate 220A1 with the first chip 220A2. The second contact 220A5 is disposed between the first substrate 220A1 and the second chip 220A3 and electrically connects the first substrate 220A1 with the second chip 220A3. The first substrate 220A1 is disposed on the first surface 210Ab of the first circuit board 210A through the first contact 205A. The first semiconductor chip assembly 220A may be disposed on the first circuit board 210A through at least one first contact 205A. The first contact 205A is, for example, solder ball, bump, pillar, pad, etc.

As illustrated in FIG. 2B, the first substrate 220A1 of the first semiconductor chip assembly 220A incudes at least one first contact 220A11 and at least one second contact 220A12, wherein the first contact 220A11 is connected with the second chips 220A3, and the second contact 220A12 is connected with the first chip 220A2.

As illustrated in FIG. 2B, the second semiconductor chip assembly 220B is disposed on the second surface 110Au of the first circuit board 110A. The second semiconductor chip assembly 220B includes the second substrate 220B1, at least one third chip 220B2, at least one fourth chip 220B3, at least one fourth contact 220B4 and at least one fifth contact 220B5. The third chip 220B2 and the fourth chip 220B3 are disposed on the first surface 220B1b of the second substrate 220B1 side by side. The fourth contact 220B4 is disposed between the second substrate 220B1 and the third chip 220B2 and electrically connects the second substrate 220B1 with the third chip 220B2. The fifth contact 220B5 is disposed between the second substrate 220B1 and the fourth chip 220B3 and electrically connects the second substrate 220B1 with the fourth chip 220B3. The second substrate 220B1 is disposed on the second surface 210Au of the first circuit board 210A through the second contact 205B. The second semiconductor chip assembly 220B may be disposed on the first circuit board 210A through at least one second contact 205B. The second contact 205B is, for example, solder ball, bump, pillar, pad, etc.

As illustrated in FIG. 2B, the second substrate 220B1 of the second semiconductor chip assembly 220B incudes at least one first contact 220B11 and at least one second contact 220B12, wherein the second substrate 220B11 is connected with the second chips 220B3, and the second contact 220B12 is connected with the first chip 220B2.

As illustrated in FIG. 2B, the first cooling unit 130A is, for example, the cold plate. The second cooling unit 130B is, for example, the cold plate. The first cooling unit 130A has at least one hole 130A1, and the second cooling unit 130B has at least one hole 130B1.

As illustrated in FIG. 2B, the second supporting component 140B and the first supporting component 140A are disposed on two opposite sides of the first circuit board 210A. For example, the first supporting component 140A connects the second cooling unit 130B with the first surface 210Ab of the first circuit board 210A, and the second supporting component 140B connects the second cooling unit 130B with the second surface 110Au of the first circuit board 110A. The first supporting component 140A has at least one hole 140A1, and the second supporting component 140B has at least one hole 140B1.

As illustrated in FIG. 2B, similar to the first fixing component 150 in FIG. 1B, the first fixing component 150 in FIG. 2B may fix the relative position among the first cooling unit 130A, the first supporting component 140A, the first circuit board 210A, the second supporting component 140B and the second cooling unit 130B.

As described above, the first semiconductor chip assembly 220A and the second semiconductor chip assembly 220B may be electrically connected through one circuit board (for example, the first circuit board 110A) and at least one contact (for example, the first contact 205A and/or the second contact 205B), and optically connected through the optical fiber (for example, the first optical fiber 190A, the second optical fiber 190B and/or the third optical fiber 195), and at least one connector (for example, the first optical fiber connector 180A and/or the second optical fiber connector 180B).

As described above, the first circuit board 210A, at least one semiconductor chip assembly (for example, the first semiconductor chip assembly 220A and/or the second semiconductor chip assembly 220B) and at least one contact (for example, the first contact 205A and/or the second contact 205B) are stacked to each other in a Z-axis (for example, a thickness direction of the semiconductor device 200), and it may reduce the area of the semiconductor device 200 in XY plane, and increase a manufacturing yield of the circuit board (due to the area of the circuit board may be reduced).

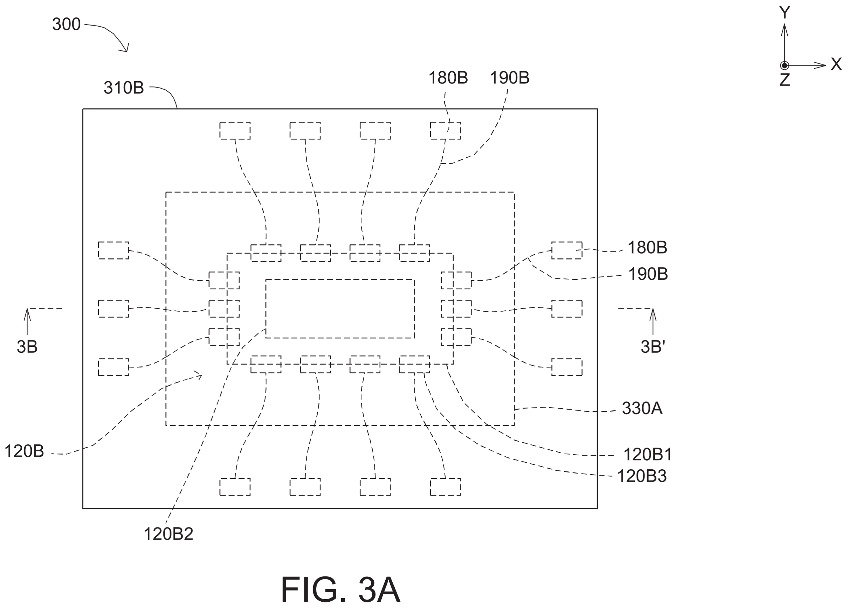

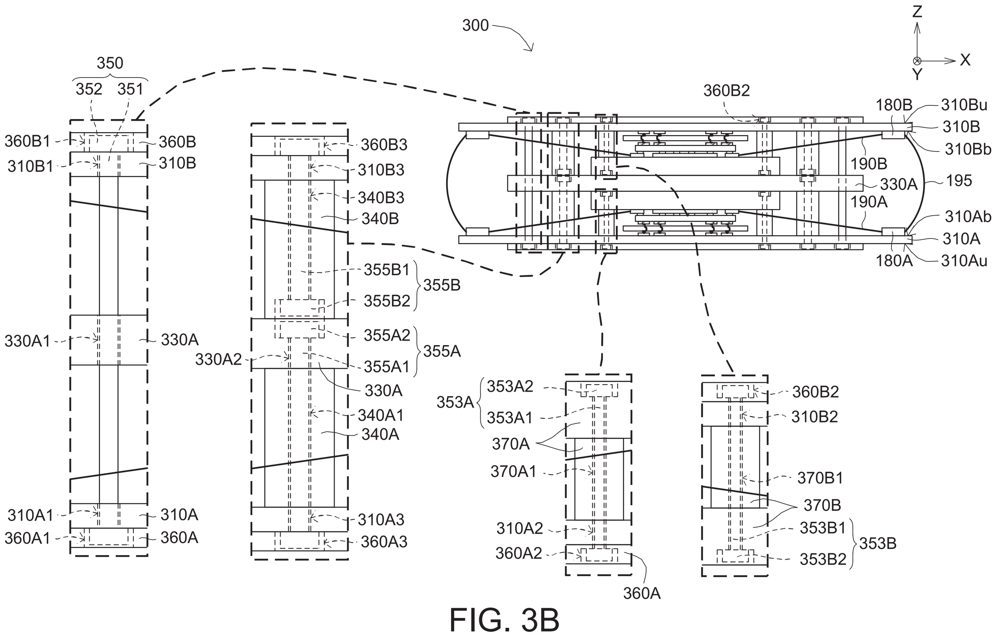

Referring to FIGS. 3A to 3B, FIG. 3A illustrates a schematic diagram of a top view of a semiconductor device 300 according to another embodiment of the invention, and FIG. 3B illustrates a cross-sectional view of the semiconductor device 300 in FIG. 3A along a direction 3B-3B'.

As illustrated in FIGS. 3A and 3B, the semiconductor device 300 includes a first circuit board 310A, a second circuit board 310B, the first semiconductor chip assembly 120A, the second semiconductor chip assembly 120B, a first cooling unit 330A, a first supporting component 340A, a second supporting component 340B, at least one first fixing component 350, at least one second fixing component 353A, at least one second fixing component 353B, at least one third fixing component 355A, at least one third fixing component 355B, the first socket 160A, the second socket 160B, at least one first optical fiber connector 180A, at least one second optical fiber connector 180B, at least one first optical fiber 190A, at least one second optical fiber 190B, at least one third optical fiber 195, a third compression component 360A and a fourth compression component 360B.

As illustrated in FIG. 3B, the first circuit board 310A has a first surface 310Ab and a second surface 310Au opposite to the first surface 310Ab. The first semiconductor chip assembly 120A is disposed on the first surface 310Ab of the first circuit board 310A. The first supporting component 340A connects the first cooling unit 330A with the first circuit board 310A. In the present embodiment, the first circuit board 310A and the first semiconductor chip assembly 120A are stacked to each other in a Z-axis (for example, a thickness direction of the semiconductor device 100), and it may reduce the area of the semiconductor device 100 in XY plane, and increase a manufacturing yield of the circuit board (due to the area of the circuit board may be reduced).

As illustrated in FIG. 3B, the second circuit board 310B has a first surface 310Bb and a second surface 310Bu opposite to the first surface 310Bb. The first surface 310Bb of the second circuit board 310B faces the first surface 310Ab of the first circuit board 310A. The second semiconductor chip assembly 120B is disposed on the first surface 310Bb of the second circuit board 310B. The second supporting component 340B connects the first cooling unit 330A with the second circuit board 310B. In the present embodiment, the second circuit board 310B and the second semiconductor chip assembly 120B are stacked to each other in a Z-axis (for example, a thickness direction of the semiconductor device 300), and it may reduce the area of the semiconductor device 100 in XY plane, and increase a manufacturing yield of the circuit board (due to the area of the circuit board may be reduced).

As illustrated in FIG. 3B, the first circuit board 310A and/or the second circuit board 310B is, for example, a PCB. The first circuit board 310A and the second circuit board 310B are disposed two opposite sides of the first cooling unit 330A. The first circuit board 310A has at least one first hole 310A1, at least one second hole 310A2 and at least one third hole 310A3. The second circuit board 310B has at least one first hole 310B1, at least one second hole 310B2 and at least one third hole 310B3.

As illustrated in FIG. 3B, the first semiconductor chip assembly 120A and the second semiconductor chip assembly 120B are disposed on two opposite sides of the first cooling unit 330A. The first semiconductor chip assembly 120A is disposed on and electrically connected with the first circuit board 310A through the first socket 160A. The second semiconductor chip assembly 120B is disposed on and electrically connected with the second circuit board 310B through the second socket 160B.

As illustrated in FIG. 3B, the first cooling unit 330A is, for example, the cold plate. The first cooling unit 330A has at least one first hole 330A1 and at least one second hole 330A2. In the present embodiment, the first hole 330A1 is, for example, through hole, and the second hole 330A2 is, for example, through hole.

As illustrated in FIG. 3B, the second supporting component 340B connects the first cooling unit 330A with the first surface 310Bb of the second circuit board 310B. The first supporting component 340A has at least one hole 340A1, and the second supporting component 340B has at least one hole 340B1.

As illustrated in FIG. 3B, the third compression component 360A is disposed the second surface 310Au of the first circuit board 310A and has at least one first hole 360A1, at least one second hole 360A2 and at least one third hole 360A3. The fourth compression component 360B is disposed the second surface 310Bu of the second circuit board 310B and has at least one first hole 360B1, at least one second hole 360B2 and at least one third hole 360B3.

As illustrated in FIG. 3B, the first fixing component 350 may fix a relative position among the third compression component 360A, the first circuit board 310A, the first cooling unit 330A, the second circuit board 310B and the fourth compression component 360B. The first fixing component 350 includes the structure the same as or similar to that of the first fixing component 150.

As illustrated in FIG. 3B, the first fixing component 350 includes a first fixing rod 351 and a first pressing portion 352, wherein the first fixing rod 351 passes through the first hole 360A1 of the third compression component 360A, the first hole 310A1 of the first circuit board 310A, the first hole 330A1 of the first cooling unit 330A, the first hole 310B1 of the second circuit board 310B and the first hole 360B1 of the fourth compression component 360B, and the first pressing portion 352 is combined to the first fixing rod 351 to fix the relative position among the third compression component 360A, the first circuit board 310A, the first cooling unit 330A, the second circuit board 310B and the fourth compression component 360B.

As illustrated in FIG. 3B, the first compression component 370A presses against the first socket 160A and the first semiconductor chip assembly 120A on the first circuit board 310A. The second compression component 370B presses against the second socket 160B and the second semiconductor chip assembly 120B on the second circuit board 310B. The first compression component 370A has at least one hole 370A1, and the second compression component 370B has at least one first hole 370B1.

As illustrated in FIG. 3B, the second fixing component 353A may fix a relative position among the first socket 160A, the third compression component 360A, the first circuit board 310A and the first compression component 370A. The second fixing component 353A includes the structure the same as or similar to that of the first fixing component 150.

As illustrated in FIG. 3B, the second fixing component 353A includes a second fixing rod 353A1 and a second pressing portion 353A2, wherein the second fixing rod 353A1 passes through the second hole 360A2 of the third compression component 360A, the second hole 310A2 of the first circuit board 310A, the hole 370A1 of the first compression component 370, and the second pressing portion 353A2 is combined to the second fixing rod 353A1 to fix the relative position among the third compression component 360A, the first circuit board 310A and the first compression component 370A.

As illustrated in FIG. 3B, the second fixing component 353B may fix a relative position among the fourth compression component 360B, the second circuit board 310B and the second compression component 370B. The second fixing component 353B includes the structure the same as or similar to that of the first fixing component 150.

As illustrated in FIG. 3B, the second fixing component 353B includes a second fixing rod 353B1 and a second pressing portion 353B2, wherein the second fixing rod 353B1 passes through the second hole 360B2 of the fourth compression component 360B, the second hole 310B2 of the second circuit board 310B and the first hole 370B1 of the second compression component 370B, and the second pressing portion 353B2 is combined to the second fixing rod 353B1 to fix the relative position among the second socket 360B, the second circuit board 310B and the second compression component 370B.

As illustrated in FIG. 3B, the third fixing component 355A may fix a relative position among the third compression component 360A, the first circuit board 310A, the first supporting component 340A and the first cooling unit 330A. The third fixing component 355A includes the structure the same as or similar to that of the first fixing component 150.

As illustrated in FIG. 3B, the third fixing component 355A includes the third fixing rod 355A1 and the third pressing portion 355A2, wherein the third fixing rod 355A1 passes through the third hole 360A3 of the third compression component 360A, the third hole 310A3 of the first circuit board 310A, the hole 340A1 of the first supporting component 340A and the second hole 330A2 of the first cooling unit 330A, and the third pressing portion 355A2 is combined to the third fixing rod 355A1 to fix the relative position among the third compression component 360A, the first circuit board 310A, the first supporting component 340A and the first cooling unit 330A.

As illustrated in FIG. 3B, the third fixing component 355B may fix a relative position among the fourth compression component 360B, the second circuit board 310B and the second supporting component 340B. The third fixing component 355B includes the structure the same as or similar to that of the first fixing component 150.

As illustrated in FIG. 3B, the third fixing component 355B includes the third fixing rod 355B1 and the third pressing portion 355B2, wherein the third fixing rod 355B1 passes through the third hole 360B3 of the fourth compression component 360B, the third hole 310B3 of the second circuit board 310B and the hole 340B1 of the second supporting component 340B, and the third pressing portion 355B2 is combined to the third fixing rod 355B1 to fix the relative position among the fourth compression component 360B, the first circuit board 310A and the first supporting component 340A.

As illustrated in FIG. 3B, at least one first optical fiber connector 180A is mechanically connected with the first surface 310Ab of the first circuit board 310A. At least one second optical fiber connector 180B is mechanically connected with the second surface 310Bu of the second circuit board 310B. The first optical fibers 190A connect the first optical fiber connectors 180A with the first semiconductor chip assembly 120A. The second optical fibers 190B connect the second optical fiber connectors 180B with the second semiconductor chip assembly 120B. The third optical fibers 195 optically connect the first optical fiber connectors 180A with the second optical fiber connectors 180B.

As described above, the first semiconductor chip assembly 120A and the second semiconductor chip assembly 120B may be electrically connected through at least one circuit board (for example, the first circuit board 310A and/or the second circuit board 310B) and at least one socket (for example, the first socket 160A and/or the second at least one 160B), and may be optically connected through the optical fiber (for example, the first optical fiber 190A, the second optical fiber 190B and/or the third optical fiber 195) and/or at least one connector (for example, the first optical fiber connector 180A and/or the second optical fiber connector 180B).

As described above, at least one (for example, the first circuit board 310A and/or the second circuit board 310B), at least one semiconductor chip assembly (for example, the first semiconductor chip assembly 120A and/or the second semiconductor chip assembly 120B) and at least one socket (for example, the first socket 160A and/or the second socket 160B) are stacked to each other in a Z-axis (for example, a thickness direction of the semiconductor device 300), and it may reduce the area of the semiconductor device 300 in XY plane, and increase a manufacturing yield of the circuit board (due to the area of the circuit board may be reduced).

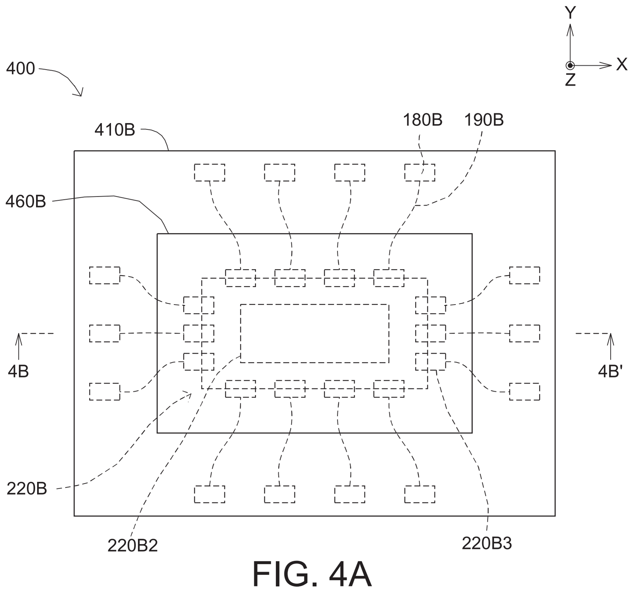

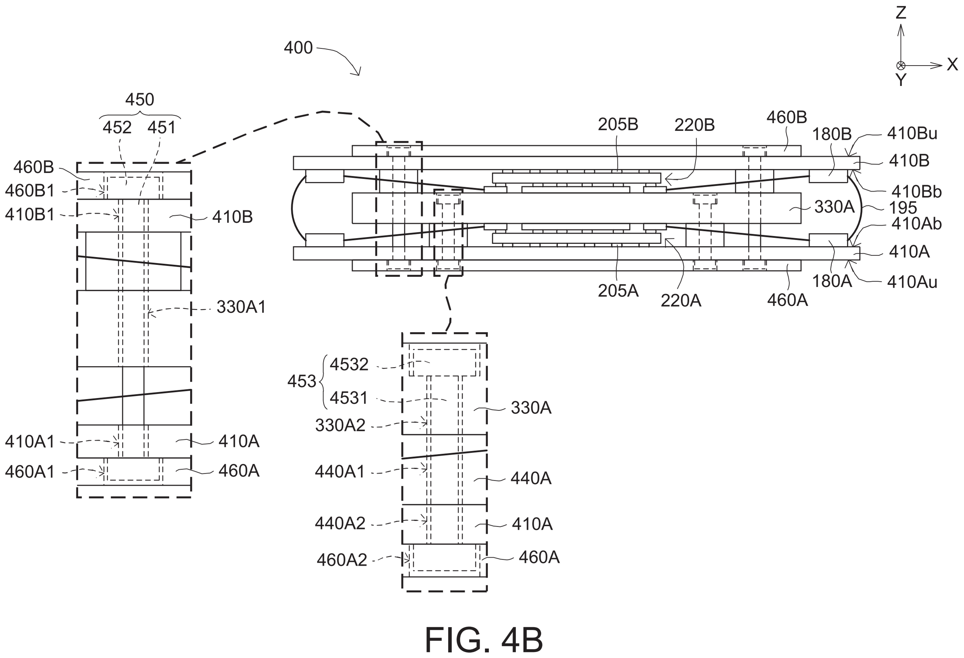

Referring to FIGS. 4A to 4B, FIG. 4A illustrates a schematic diagram of a top view of a semiconductor device 400 according to another embodiment of the invention, and FIG. 4B illustrates a cross-sectional view of the semiconductor device 400 in FIG. 4A along a direction 4B-4B'.

As illustrated in FIGS. 4A and 4B, the semiconductor device 400 includes a first circuit board 410A, a second circuit board 410B, at least one first contact 205A, at least one second contact 205B, the first semiconductor chip assembly 220A, the second semiconductor chip assembly 220B, the first cooling unit 330A, a first supporting component 440A, at least one first fixing component 450, at least one second fixing component 452, at least one first optical fiber connector 180A, at least one second optical fiber connector 180B, at least one first optical fiber 190A, at least one second optical fiber 190B, at least one third optical fiber 195, a third compression component 460A and a fourth compression component 460B.

As illustrated in FIG. 4B, the first semiconductor chip assembly 220A and the second semiconductor chip assembly 220A are disposed on two opposite sides of the first cooling unit 330A. The first semiconductor chip assembly 220A is disposed on the first circuit board 410A through the first contact 205A. The second semiconductor chip assembly 220B is disposed on the second circuit board 410B through the second contact 205B.

As illustrated in FIG. 4B, the first circuit board 410A has a first surface 410Ab and a second surface 410Au opposite to the first surface 410Ab. The first semiconductor chip assembly 220A is disposed on the first surface 410Ab of the first circuit board 410A. The first supporting component 440A connects the first cooling unit 330A with the first circuit board 410A. In the present embodiment, the first circuit board 410A and the first semiconductor chip assembly 120A are stacked to each other in a Z-axis (for example, a thickness direction of the semiconductor device 400), and it may reduce the area of the semiconductor device 100 in XY plane, and increase a manufacturing yield of the circuit board (due to the area of the circuit board may be reduced).

As illustrated in FIG. 4B, the second circuit board 410B has a first surface 410Bb and a second surface 410Bu opposite to the first surface 410Bb. The first surface 410Bb of the second circuit board 410B faces the first surface 410Ab of the second circuit board 410A. The second semiconductor chip assembly 220B is disposed on the first surface 410Bb of the second circuit board 410B. In addition, the first circuit board 410A has at least one first hole 410A1 and at least one second hole 410A2, and the second circuit board 410B has at least one first hole 410B1 and at least one second hole 410B2.

As illustrated in FIG. 4B, the first cooling unit 330A is, for example, the cold plate. The first cooling unit 330A has at least one first hole 330A1 and at least one second hole 330A2. In the present embodiment, the first hole 330A1 is, for example, through hole, and the second hole 330A2 is, for example, through hole.

As illustrated in FIG. 4B, the third compression component 460A is disposed the second surface 410Au of the first circuit board 410A and has at least one first hole 460A1 and at least one second hole 460A2. The fourth compression component 460B is disposed the second surface 410Bu of the second circuit board 410B and has at least one first hole 460B1 and at least one second hole 460B2.

As illustrated in FIG. 4B, the first fixing component 450 may fix a relative position among the third compression component 460A, the first circuit board 410A, the first cooling unit 330A, the second circuit board 410B and the fourth compression component 460B. The first fixing component 450 includes the structure the same as or similar to that of the first fixing component 150.

As illustrated in FIG. 4B, the first fixing component 450 includes a first fixing rod 451 and a first pressing portion 452, wherein the first fixing rod 451 passes through the first hole 460A1 of the third compression component 460A, the first hole 410A1 of the first circuit board 410A, the first hole 330A1 of the first cooling unit 330A, the first hole 410B1 of the second circuit board 410B and the first hole 460B1 of the fourth compression component 460B, and the first pressing portion 452 is combined to the first fixing rod 451 to fix the relative position among the third compression component 460A, the first circuit board 410A, the first cooling unit 330A, the second circuit board 310B and the fourth compression component 360B.

As illustrated in FIG. 4B, the second fixing component 453 may fix a relative position among the third compression component 460A, the first circuit board 410A, the first supporting component 440A and the first cooling unit 330A. The second fixing component 453 includes the structure the same as or similar to that of the first fixing component 150.

As illustrated in FIG. 4B, the second fixing component 453 includes a second fixing rod 4531 and a second pressing portion 4532, wherein the second fixing rod 4531 passes through the second hole 460A2 of the third compression component 460A, the second hole 410A2 of the first circuit board 410A, a hole 440A1 of the first supporting component 440A and the second hole 330A2 of the first cooling unit 330A to fix the relative position among the third compression component 460A, the first circuit board 410A, the first supporting component 440A and the first cooling unit 330A.

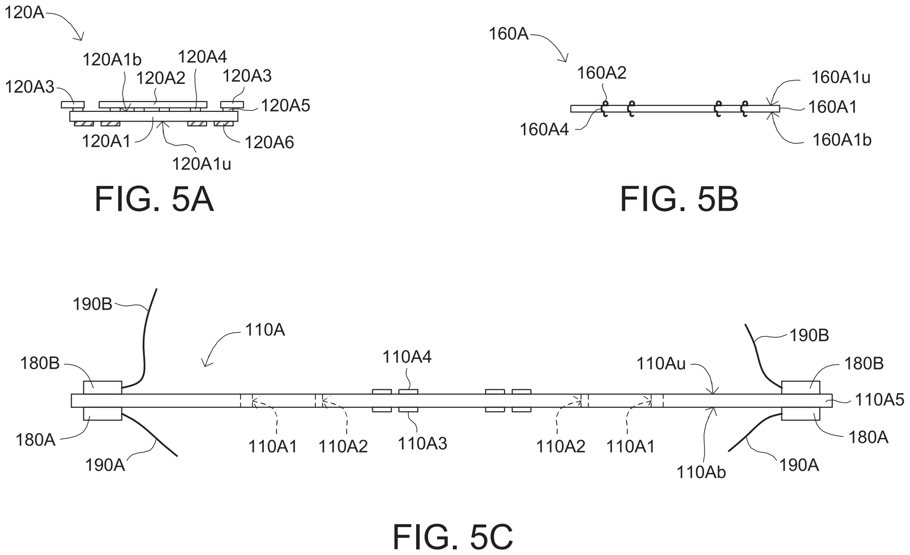

Referring to FIGS. 5A to 5H, FIGS. 5A to 5H illustrate schematic diagrams of manufacturing processes of the semiconductor device 100 in FIG. 1B.

As illustrated in FIG. 5A, the first semiconductor chip assembly 120A is provided. The first semiconductor chip assembly 120A includes the first substrate 120A1, at least one first chip 120A2, at least one second chip 120A3, at least one first contact 120A4, at least one second contact 120A5 and at least one third contact 120A6. The first substrate 120A1 is, for example, a printed circuit board, an interposer, a portion of a silicon wafer, etc. The first chip 120A2 and the second chip 120A3 are disposed on the first surface 120A1b of the first substrate 120A1 side by side. The first chip 120A2 is, for example, an ASIC, etc., and the second chip 120A3 is, for example, PIC, etc. The first contact 120A4 is disposed between the first substrate 120A1 and the first chip 120A2 and electrically connects the first substrate 120A1 with the first chip 120A2. The second contact 120A5 is disposed between the first substrate 120A1 and the second chip 120A3 and electrically connects the first substrate 120A1 with the second chip 120A3. The third contact 120A6 is disposed on the second surface 120A1u of the first substrate 120A1. The first contact 120A4, the second contact 120A5 and/or the third contact 120A6 is, for example, solder ball, bump, pillar, pad, etc. In addition, the first substrate 120A1 of the first semiconductor chip assembly 120A incudes at least one first contact 120A11 and at least one second contact 120A12, wherein the first contact 120A11 is connected with the second chips 120A3 through the second contact 120A5, and the second contact 120A12 is connected with the first chip 120A2 through the second contact 120A5. The first semiconductor chip assembly 120A may be heated to cure the second contact 120A5 by reflow process.

As illustrated in FIG. 5B, the first socket 160A is provided. The first socket 160A incudes the socket body 160A1, at least one contact 160A2 and at least one conductive spring 160A4, wherein the socket body 160A1 has the first surface 160A1u and a second surface 160A1 b opposite to the first surface 160A1u, the contact 160A2 is disposed on the second surface 160A1 b, the conductive spring 160A4 connects the contact 160A2 and electrically connected with the contact 160A2.

As illustrated in FIG. 5C, the first circuit board 110A is provided. The first circuit board 110A has at least one first hole 110A1 and at least one second hole 110A2. At least one first optical fiber connector 180A is mechanically connected with the first surface 110Ab of the first circuit board 110A, and at least one second optical fiber connector 180B is mechanically connected with the second surface 110Au of the first circuit board 110A. At least one first optical fiber 190A is mechanically connected with the first optical fiber connector 180A, and at least one second optical fiber 190B is mechanically connected with the second optical fiber connector 180B. An optical signal may be transmitted between two optical fibers connected with each other. In addition, the first contact 110A3 and the second contact 110A4 are disposed on the first surface 110Ab and the second surface 110Au respectively. The first contact 110A3 and the second contact 110A4 are electrically connected with each other through at least conductive structure (for example, RDL, at least one trace, at least one pad, at least one via, etc.) in or on the board body 110A5.

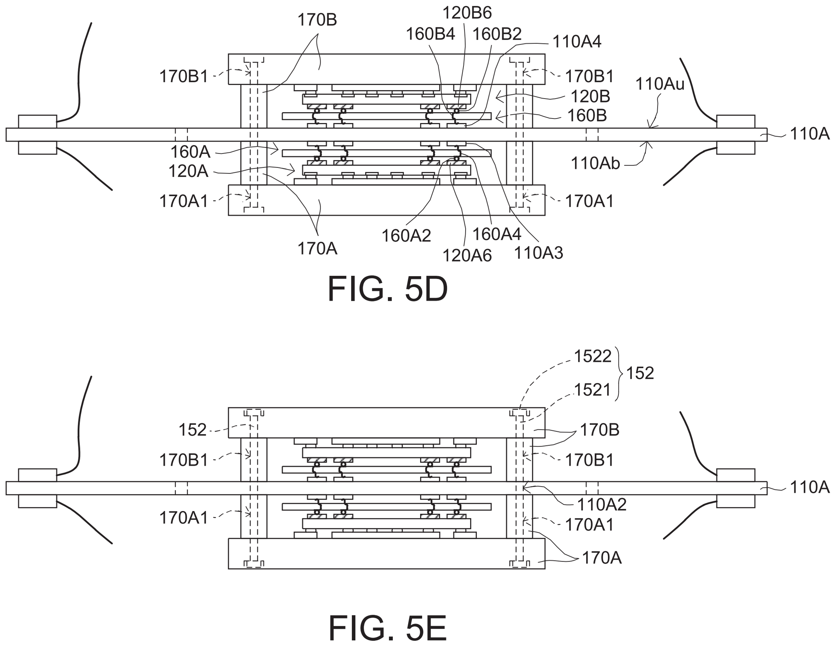

As illustrated in FIG. 5D, the first semiconductor chip assembly 120A and the first socket 160A are disposed between the first compression component 170A and the first surface 110Ab of the first circuit board 110A. The first compression component 170A may press the first semiconductor chip assembly 120A and the first socket 160A against the first surface 110Ab of the first circuit board 110A. The first socket 160A may be electrically connected with the first circuit board 110A. Similarly, the second semiconductor chip assembly 120B and the second socket 160B are disposed between the second compression component 170B and the second surface 110Au of the first circuit board 110A. The second compression component 170B may press the second semiconductor chip assembly 120B and the second socket 160B against the second surface 110Au of the first circuit board 110A. The second socket 160b may be electrically connected with the first circuit board 110A.

The third contact 120A6 of the first semiconductor chip assembly 120A is in contact with the contact 160A2 of the first socket 160A, and electrically connected with the first circuit board 110A through the contact 160A2, the conductive spring 160A4 and the first contact 110A3. Similarly, the third contact 120B6 of the second semiconductor chip assembly 120B is in contact with the contact 160B2 of second first socket 160B, and electrically connected with the first circuit board 110A through the contact 160B2, the conductive spring 160B4 and the second contact 110A4.

In addition, the first compression component 170A has at least one hole 170A1, and the second compression component 170B has at least one hole 170B1. The hole 170A1, the hole 170B1 and the second hole 110A2 are aligned with each other in Z-axis.

As illustrated in FIG. 5E, at least one second fixing component 152 may fix the relative position among the first compression component 170A, the first circuit board 110A and the second compression component 170B. Furthermore, the second fixing component 152 includes the second fixing rod 1521 and the second pressing portion 1522, wherein the second fixing rod 1521 passes through the hole 170A1 of the first compression component 170A, the second hole 110A2 of the first circuit board 110A and the hole 170B1 of the second compression component 170B, and the second pressing portion 1522 is combined to the second fixing rod 1521 to fix the relative position among the first circuit board 110A, the first compression component 170A and the second compression component 170B. In an embodiment, the second fixing rod 1521 is, for example, bolt, and the second pressing portion 1522 is, for example, nut.

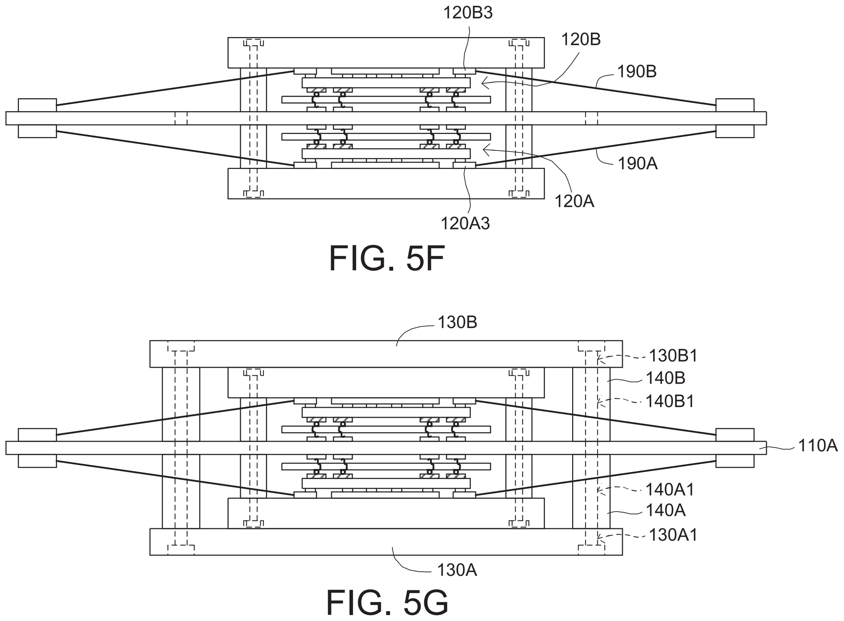

As illustrated in FIG. 5F, the first optical fiber 190A connecting the first optical fiber connector 180A is connected to the second chip 120A3 of the first semiconductor chip assembly 120A. Although not illustrated, the second chip 120A3 may include an optical fiber connector which may be connected to the first optical fiber 190A. Similarly, the second optical fiber 190B connecting the second optical fiber connector 180B is connected to the second chip 120B3 of the second semiconductor chip assembly 120B. Although not illustrated, the second chip 120B3 may include an optical fiber connector which may be connected to the second optical fiber 190B.

As illustrated in FIG. 5G, the first supporting component 140A is disposed between the first circuit board 110A and the first cooling unit 130A, and the second supporting component 140B is disposed between the first circuit board 110A and the second cooling unit 130B. The first cooling unit 130A has at least one hole 130A1, the second cooling unit 130B has at least one hole 130B1, the first supporting component 140A has at least one hole 140A1, and the second supporting component 140B has at least one hole 140B1, wherein the hole 130A1, the hole 130B1, the hole 140A1 and the hole 140B1 are aligned with each other in Z-axis.

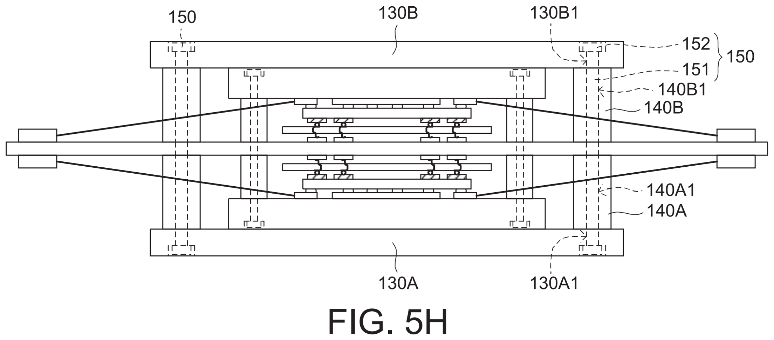

As illustrated in FIG. 5H, the first fixing component 150 may fix the relative position among the first circuit board 110A, the first cooling unit 130A, the second cooling unit 130B, the first supporting component 140A and the second supporting component 140B. Furthermore, the first fixing component 150 includes the first fixing rod 151 and the first pressing portion 152, wherein the first fixing rod 151 passes through the hole 130A1 of the first cooling unit 130A, the hole 140A1 of the first supporting component 140A, the first hole 110A1 of the first circuit board 110A, the hole 130B1 of the second cooling unit 130B and the hole 140B1 of the second supporting component 140B, and the first pressing portion 152 is combined to the first fixing rod 151 to fix the relative position among the first circuit board 110A, the first cooling unit 130A and the second cooling unit 130B, the first supporting component 140A and the second supporting component 140B. In an embodiment, the first fixing rod 151 is, for example, bolt, and the first pressing portion 152 is, for example, nut.

Then, at least one third optical fiber 195 in FIG. 1B connects the first optical fiber connector 180A with the second optical fiber connector 180B cross over a lateral surface of the first circuit board 110A to form the semiconductor device 100 as illustrated in FIG. 1B.

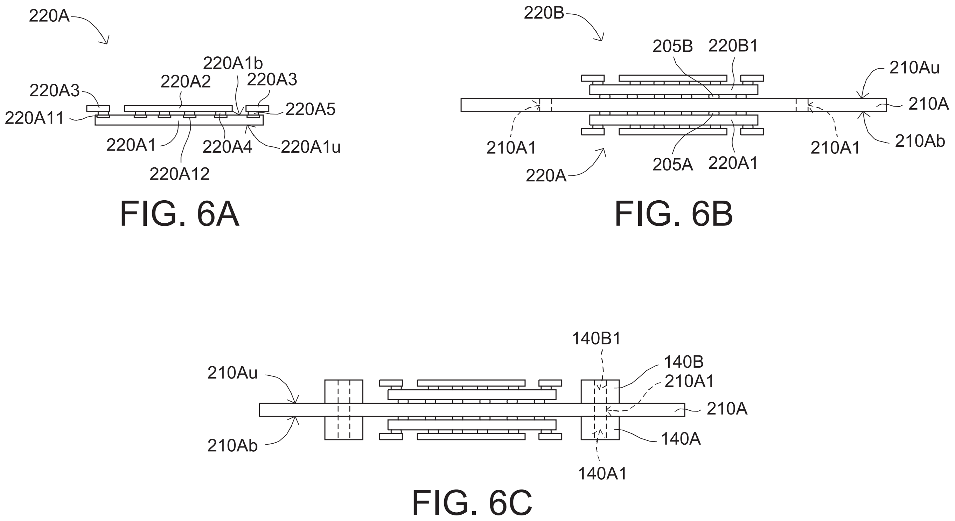

Referring to FIGS. 6A to 6F, FIGS. 6A to 6F illustrate schematic diagrams of manufacturing processes of the semiconductor device 200 in FIG. 2B.

As illustrated in FIG. 6A, the first semiconductor chip assembly 220A is provided. The first semiconductor chip assembly 220A includes the first substrate 220A1, at least one first chip 220A2, at least one second chip 220A3, at least one first contact 220A4 and at least one second contact 220A5. The first chip 220A2 and the second chip 220A3 are disposed on the first surface 220A1b of the first substrate 220A1 side by side. The first contact 220A4 is disposed between the first substrate 220A1 and the first chip 220A2 and electrically connects the first substrate 220A1 with the first chip 220A2. The second contact 220A5 is disposed between the first substrate 220A1 and the second chip 220A3 and electrically connects the first substrate 220A1 with the second chip 220A3. In addition, the first substrate 220A1 of the first semiconductor chip assembly 220A incudes at least one first contact 220A11 and at least one second contact 220A12, wherein the first contact 220A11 is connected with the second chips 220A3 through the second contact 220A5, and the second contact 220A12 is connected with the first chip 220A2 through the second contact 220A5. The first semiconductor chip assembly 220A may be heated to cure the second contact 220A5 by reflow process.

As illustrated in FIG. 6B, the first semiconductor chip assembly 220A is disposed on the first surface 210Ab of the first circuit board 210A through at least one first contact 205A, the second semiconductor chip assembly 220B is disposed on the second surface 210Au of the first circuit board 210A through at least one second contact 205B. The first contact 205A and the second contact 205B are cured by heating (for example, reflow). In addition, the first circuit board 210A has at least one hole 210A1.

As illustrated in FIG. 6C, the first supporting component 140A and the second supporting component 140B are disposed on the first surface 210Ab and the second surface 210Au respectively. In addition, the first supporting component 140A has at least one hole 140A1, and the second supporting component 140B has at least one hole 140B1, wherein the hole 140A1 of the first supporting component 140A, the hole 210A1 of the first circuit board 110A and the hole 140B1 of the second supporting component 140B are aligned with each other in Z-axis.

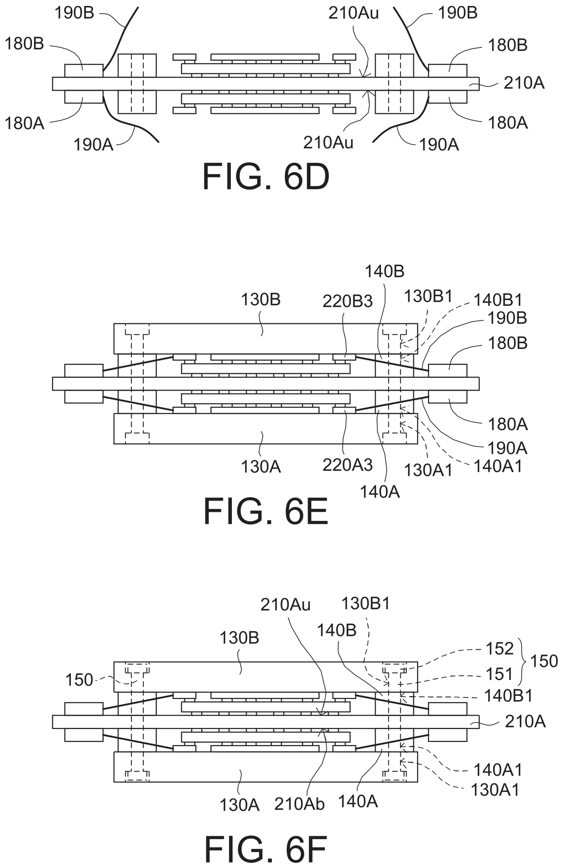

As illustrated in FIG. 6D, at least one first optical fiber connector 180A is mechanically connected with the first surface 210Ab of the first circuit board 210A, and at least one second optical fiber connector 180B is mechanically connected with the second surface 210Au of the first circuit board 210A. At least one first optical fiber 190A is mechanically connected with the first optical fiber connector 180A, and at least one second optical fiber 190B is mechanically connected with the second optical fiber connector 180B.

As illustrated in FIG. 6E, the first supporting component 140A is disposed between the first circuit board 210A and the first cooling unit 130A, and the second supporting component 140B is disposed between the first circuit board 110A and the second cooling unit 130B. The first cooling unit 130A has at least one hole 130A1, the second cooling unit 130B has at least one hole 130B1, the first supporting component 140A has at least one hole 140A1, and the second supporting component 140B has at least one hole 140B1, wherein the hole 130A1, the hole 130B1, the hole 140A1 and the hole 140B1 are aligned with each other in Z-axis.

As illustrated in FIG. 6F, the first fixing component 150 may fix the relative position among the first circuit board 210A, the first cooling unit 130A, the second cooling unit 130B, the first supporting component 140A and the second supporting component 140B. Furthermore, the first fixing component 150 includes the first fixing rod 151 and the first pressing portion 152, wherein the first fixing rod 151 passes through the hole 130A1 of the first cooling unit 130A, the hole 140A1 of the first supporting component 140A, the first hole 110A1 of the first circuit board 110A, the hole 130B1 of the second cooling unit 130B and the hole 140B1 of the second supporting component 140B, and the first pressing portion 152 is combined to the first fixing rod 151 to fix the relative position among the first circuit board 110A, the first cooling unit 130A and the second cooling unit 130B, the first supporting component 140A and the second supporting component 140B. In an embodiment, the first fixing rod 151 is, for example, bolt, and the first pressing portion 152 is, for example, nut.

Then, at least one third optical fiber 195 in FIG. 2B connects the first optical fiber connector 180A with the second optical fiber connector 180B cross over a lateral surface of the first circuit board 210A to form the semiconductor device 200 as illustrated in FIG. 2B.

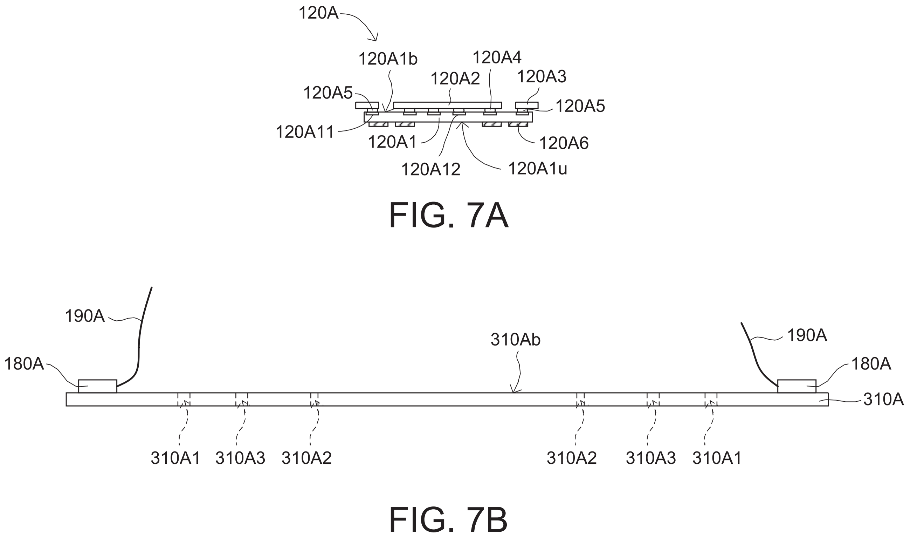

Referring to FIGS. 7A to 7G, FIGS. 7A to 7G illustrate schematic diagrams of manufacturing processes of the semiconductor device 300 in FIG. 3B.

As illustrated in FIG. 7A, the first semiconductor chip assembly 120A is provided. The first semiconductor chip assembly 120A includes the first substrate 120A1, at least one first chip 120A2, at least one second chip 120A3, at least one first contact 120A4, at least one second contact 120A5 and at least one third contact 120A6. The first substrate 120A1 is, for example, a printed circuit board, an interposer, a portion of a silicon wafer, etc. The first chip 120A2 and the second chip 120A3 are disposed on the first surface 120A1b of the first substrate 120A1 side by side. The first chip 120A2 is, for example, an ASIC, etc., and the second chip 120A3 is, for example, PIC, etc. The first contact 120A4 is disposed between the first substrate 120A1 and the first chip 120A2 and electrically connects the first substrate 120A1 with the first chip 120A2. The second contact 120A5 is disposed between the first substrate 120A1 and the second chip 120A3 and electrically connects the first substrate 120A1 with the second chip 120A3. The third contact 120A6 is disposed on the second surface 120A1u of the first substrate 120A1. The first contact 120A4, the second contact 120A5 and/or the third contact 120A6 is, for example, solder ball, bump, pillar, pad, etc.

As illustrated in FIG. 7B, the first circuit board 310A is provided. The first circuit board 310A includes at least one first hole 310A1, at least one second hole 310A2, at least one second hole 310A3, at least one the second contact 110A4 and a board body 310A5,. The first hole 310A1, the second hole 310A2 and the second hole 310A3 penetrate the board body 310A5, and the second contacts 110A4 are disposed on the first surface 310Ab. At least one first optical fiber connector 180A is mechanically connected with the first surface 310Ab of the first circuit board 310A. At least one first optical fiber 190A is mechanically connected with the first optical fiber connector 180A.

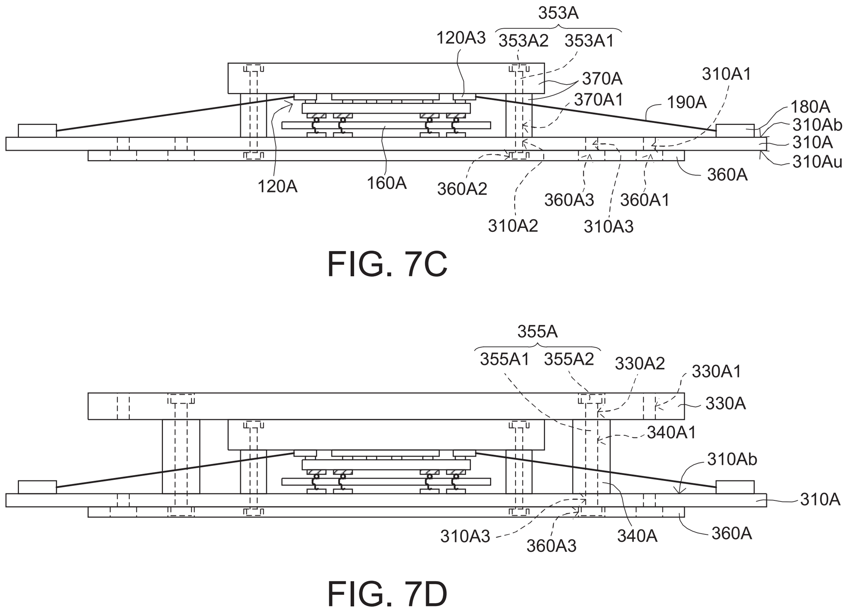

As illustrated in FIG. 7C, the first semiconductor chip assembly 120A and the first socket 160A are disposed between the first compression component 370A and the first surface 310Ab of the first circuit board 310A. The third compression component 360A is disposed the second surface 310Au of the first circuit board 310A and has at least one first hole 360A1, at least one second hole 360A2 and at least one third hole 360A3. The first compression component 370A may press the first semiconductor chip assembly 120A and the first socket 160A against the first surface 310Ab of the first circuit board 310A. The first socket 160A may be electrically connected with the first circuit board 310A. The first compression component 370A has at least one hole 370A1, wherein the hole 370A1 of the first compression component 370A, the second hole 310A2 of the first circuit board 310A and the second hole 360A2 of the third compression component 360A are aligned with each other in Z-axis.

Then, the second fixing component 353A may fix a relative position among the third compression component 360A, the first circuit board 310A and the first compression component 370A. The second fixing component 353A includes the structure the same as or similar to that of the first fixing component 150. The second fixing component 353A includes the second fixing rod 353A1 and the second pressing portion 353A2, wherein the second fixing rod 353A1 passes through the second hole 360A2 of the third compression component 360A, the second hole 310A2 of the first circuit board 310A, the hole 370A1 of the first compression component 370, and the second pressing portion 353A2 is combined to the second fixing rod 353A1 to fix the relative position among the third compression component 360A, the first circuit board 310A and the first compression component 370A.

Then, the first optical fiber 190A connecting the first optical fiber connector 180A is connected to the second chip 120A3 of the first semiconductor chip assembly 120A.

As illustrated in FIG. 7D, the first supporting component 340A is disposed between the first cooling unit 330A and the first circuit board 310A. The first supporting component 340A has at least one hole 340A1, and the first cooling unit 330A has at least one first hole 330A1 and at least one second hole 330A2, wherein the hole 340A1, the hole 310A3 and the hole 360A3 are aligned with each other in Z-axis.

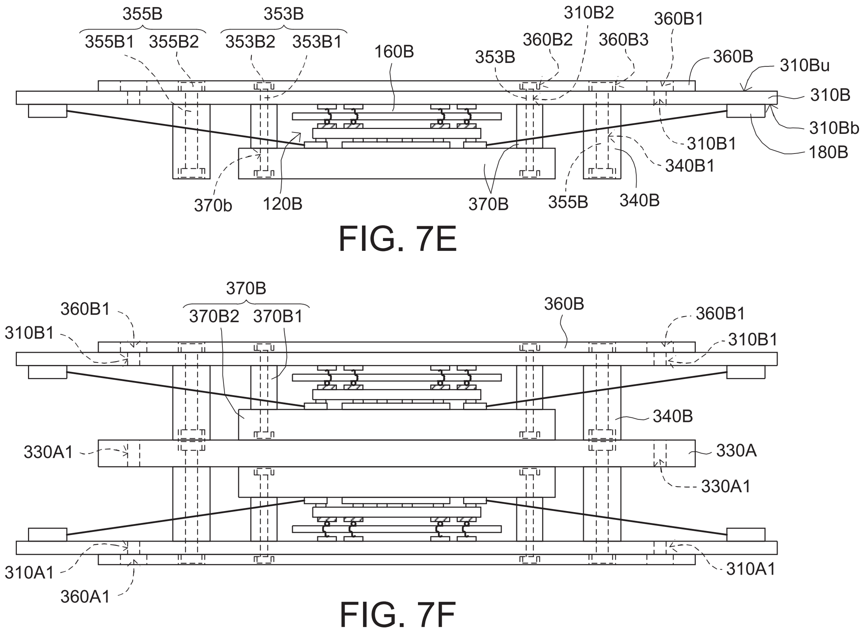

As illustrated in FIG. 7E, the second semiconductor chip assembly 120B and the second socket 160B are disposed between the second compression component 370B and the first surface 310Bb of the second circuit board 310B. The fourth compression component 360B is disposed the second surface 310Au of the second circuit board 310B and has at least one first hole 360B1, at least one second hole 360B2 and at least one third hole 360B3. The second compression component 370B may press the first semiconductor chip assembly 120A and the first socket 160A against the first surface 310Ab of the second circuit board 310B. The first socket 160A may be electrically connected with the second circuit board 310B. The second compression component 370B has at least one hole 370B1, wherein the hole 370B1 of the first compression component 370A, the second hole 310A2 of the first circuit board 310A and the second hole 360A2 of the third compression component 360A are aligned with each other in Z-axis. Then, the second fixing component 353B may fix the relative position among the fourth compression component 360B, the second circuit board 310B and the second compression component 370B. The second fixing component 353B includes the structure the same as or similar to that of the first fixing component 150. The second fixing component 353B includes the second fixing rod 353B1 and the second pressing portion 353B2, wherein the second fixing rod 353B1 passes through the second hole 360B2 of the fourth compression component 360B, the second hole 310B2 of the second circuit board 310B and the first hole 370B1 of the second compression component 370B, and the second pressing portion 353B2 is combined to the second fixing rod 353B1 to fix the relative position among the second socket 360B, the second circuit board 310B and the second compression component 370B.

Then, the second supporting component 340B is disposed on the first surface 310Ab of the first circuit board 310A. The second supporting component 340B has at least one hole 340B1.

Then, the third fixing component 355B may fix the relative position among the fourth compression component 360B, the second circuit board 310B and the second supporting component 340B. Furthermore, the third fixing component 355B includes the third fixing rod 355B1 and the third pressing portion 355B2, wherein the third fixing rod 355B1 passes through the third hole 360B3 of the fourth compression component 360B, the third hole 310B3 of the second circuit board 310B and the hole 340B1 of the second supporting component 340B, and the third pressing portion 355B2 is combined to the third fixing rod 355B1 to fix the relative position among the fourth compression component 360B, the first circuit board 310A and the first supporting component 340A.

As illustrated in FIG. 7F, the structure in FIG. 7E is stacked to the structure in FIG. 7D. The second compression component 370B is disposed on the first cooling unit 330A, wherein the second compression component 370B and the first compression component 370A are disposed on two opposite sides of the first cooling unit 330A. The first hole 360B1 of the fourth compression component 360B, the first hole 310B1 of the second circuit board 310B, the first hole 330A1 of the first cooling unit 330A, the first hole 360A1 of the third compression component 360A and the first hole 310A1 of the first circuit board 310A.

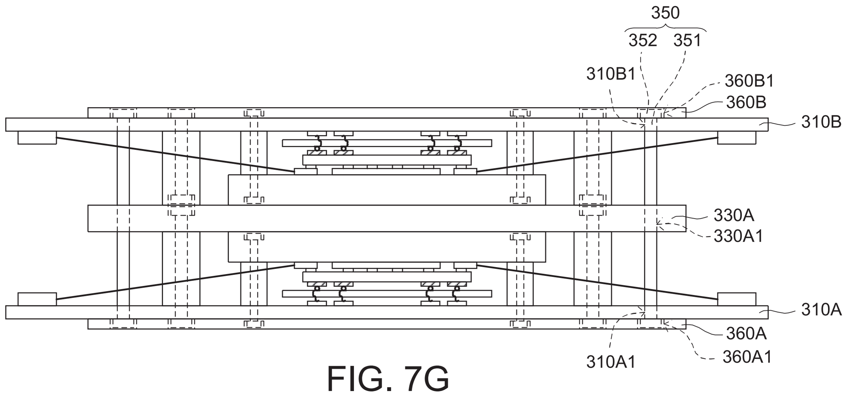

As illustrated in FIG. 7G, the first fixing component 350 may fix the relative position among the third compression component 360A, the first circuit board 310A, the first cooling unit 330A, the second circuit board 310B and the fourth compression component 360B. Furthermore, the first fixing component 350 includes the first fixing rod 351 and the first pressing portion 352, wherein the first fixing rod 351 passes through the first hole 360A1 of the third compression component 360A, the first hole 310A1 of the first circuit board 310A, the first hole 330A1 of the first cooling unit 330A, the first hole 310B1 of the second circuit board 310B and the first hole 360B1 of the fourth compression component 360B, and the first pressing portion 352 is combined to the first fixing rod 351 to fix the relative position among the third compression component 360A, the first circuit board 310A, the first cooling unit 330A, the second circuit board 310B and the fourth compression component 360B.

Then, at least one third optical fiber 195 in FIG. 3B connects the first optical fiber connector 180A with the second optical fiber connector 180B to form the semiconductor device 300 as illustrated in FIG. 3B.

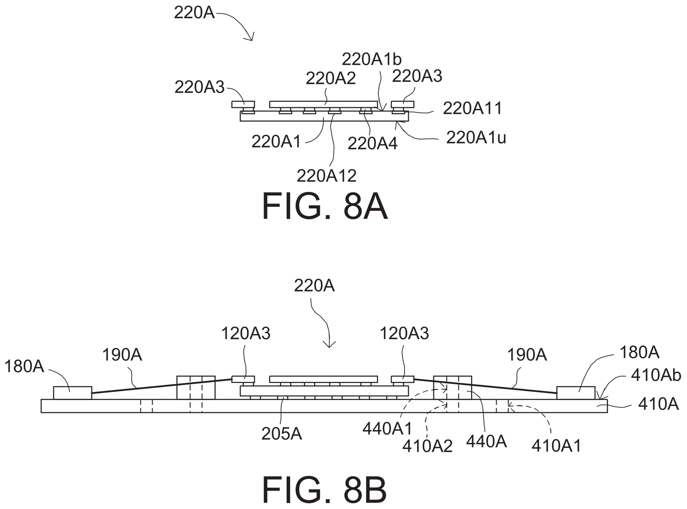

Referring to FGIS. 8A to 8E, FIGS. 8A to 8E illustrate schematic diagrams of manufacturing processes of the semiconductor device 400 in FIG. 4B.

As illustrated in FIG. 8A, the first semiconductor chip assembly 220A is provided. The first semiconductor chip assembly 220A includes the first substrate 220A1, at least one first chip 220A2, at least one second chip 220A3, at least one first contact 220A4 and at least one second contact 220A5. The first chip 220A2 and the second chip 220A3 are disposed on the first surface 220A1b of the first substrate 220A1 side by side. The first contact 220A4 is disposed between the first substrate 220A1 and the first chip 220A2 and electrically connects the first substrate 220A1 with the first chip 220A2. The second contact 220A5 is disposed between the first substrate 220A1 and the second chip 220A3 and electrically connects the first substrate 220A1 with the second chip 220A3.

As illustrated in FIG. 8B, the first semiconductor chip assembly 220A is disposed on the first surface 410Ab of the first circuit board 410A through at least one first contact 205A, and the first supporting component 440A is disposed on the first surface 410Ab. The first circuit board 410A has at least one first hole 410A1 and at least one second hole 410A2, and the first supporting component 440A has at least one hole 440A1. The second hole 410A2 and the hole 440A1 are aligned with each other in Z-axis. Then, the first optical fiber 190A connecting the first optical fiber connector 180A is connected to the second chip 220A3 of the first semiconductor chip assembly 220A.

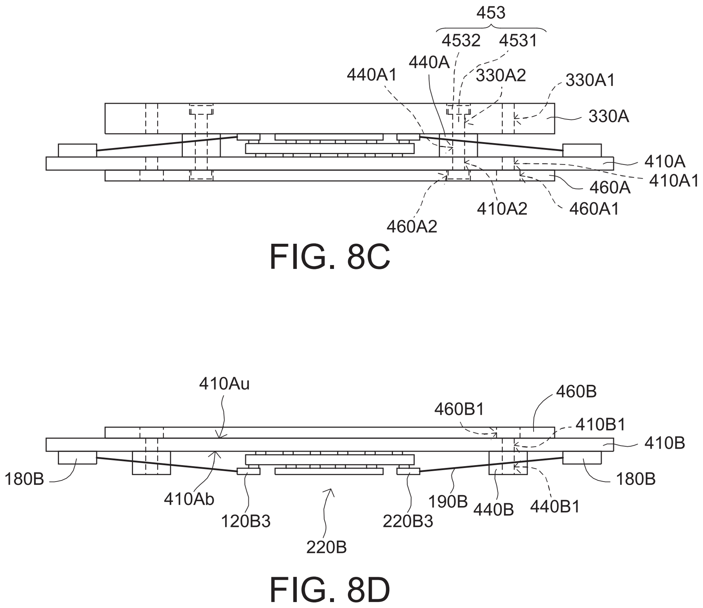

As illustrated in FIG. 8C, the first cooling unit 330A is disposed on the first supporting component 440A. The first cooling unit 330A has at least one first hole 330A1 and at least one second hole 330A2. The second hole 330A2, the second hole 410A2 and the hole 440A1 are aligned with each other in Z-axis.

Then, the second fixing component 453 may fix the relative position among the third compression component 460A, the first circuit board 410A, the first supporting component 440A and the first cooling unit 330A. Furthermore, the second fixing component 453 includes the second fixing rod 4531 and the second pressing portion 4532, wherein the second fixing rod 4531 passes through the second hole 460A2 of the third compression component 460A, the second hole 410A2 of the first circuit board 410A, the hole 440A1 of the first supporting component 440A and the second hole 330A2 of the first cooling unit 330A to fix the relative position among the third compression component 460A, the first circuit board 410A, the first supporting component 440A and the first cooling unit 330A.

As illustrated in FIG. 8D, the first semiconductor chip assembly 220B is disposed on the first surface 410Bb of the first circuit board 410B through at least one second contact 205B, and the second supporting component 440B is disposed on the first surface 410Bb. The fourth compression component 460B is disposed on the second surface 410Au of the second circuit board 410B. The second circuit board 410B has at least one first hole 410B1, the second supporting component 440B has at least one hole 440B1, and the fourth compression component 460B has at least one hole 460B1. The first hole 410B1, the hole 440B1 and the hole 460B1 are aligned with each other in Z-axis.

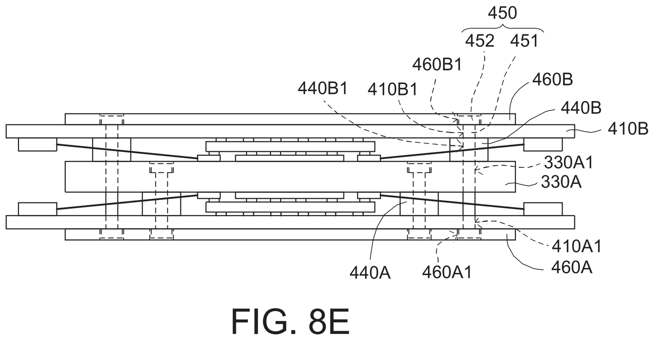

As illustrated in FIG. 8E, the structure in FIG. 8D is stacked to the structure in FIG. 8C. The second supporting component 440B is disposed on the first cooling unit 330A, wherein the first supporting component 440A, and the second supporting component 440B are disposed on two opposite sides of the first cooling unit 330A. The hole 460B1, the first hole 410B1, the hole 440B1, first hole 330A1, the first hole 410A1 and the first hole 460A1 are aligned with each other in Z-axis.

Then, the first fixing component 450 may fix the relative position among the third compression component 460A, the first circuit board 410A, the first cooling unit 330A, the second circuit board 410B and the fourth compression component 460B. Furthermore, the first fixing component 450 includes the first fixing rod 451 and the first pressing portion 452, wherein the first fixing rod 451 passes through the first hole 460A1 of the third compression component 460A, the first hole 410A1 of the first circuit board 410A, the first hole 330A1 of the first cooling unit 330A, the first hole 410B1 of the second circuit board 410B and the first hole 460B1 of the fourth compression component 460B, and the first pressing portion 452 is combined to the first fixing rod 451 to fix the relative position among the third compression component 460A, the first circuit board 410A, the first cooling unit 330A, the second circuit board 310B and the fourth compression component 360B.

Then, at least one third optical fiber 195 in FIG. 4B connects the first optical fiber connector 180A with the second optical fiber connector 180B cross over a lateral surface of the first circuit board 110A to form the semiconductor device 400 as illustrated in FIG. 4B.

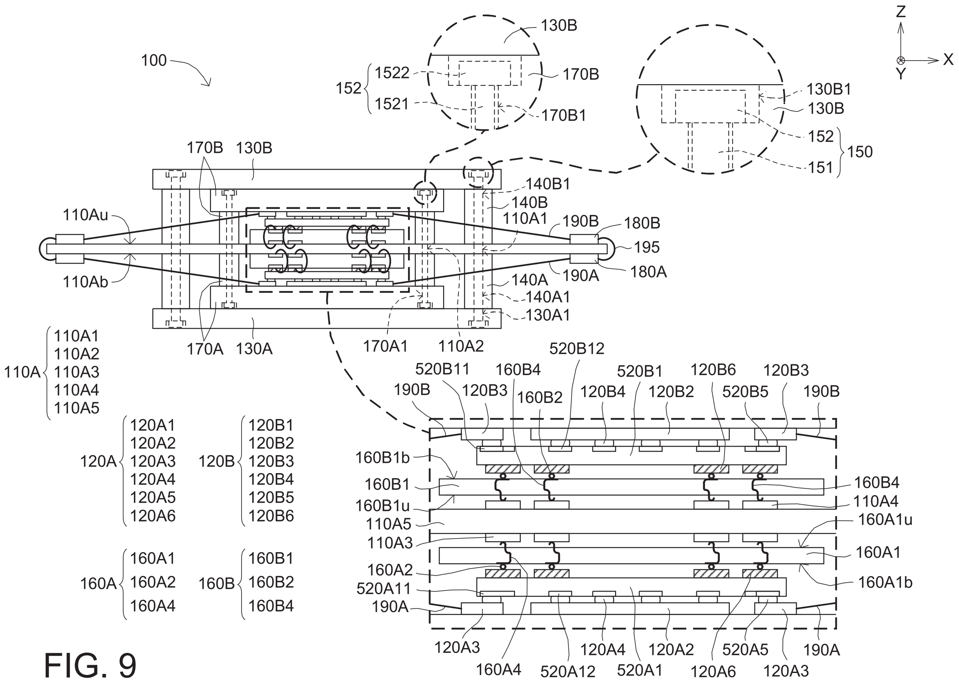

Referring to FIG. 9, FIG. 9 illustrates a schematic diagram of a cross-sectional view of a semiconductor device 500 according to another embodiment of the invention.

As illustrated in FIG. 9, the semiconductor device 500 includes a first circuit board 110A, a first semiconductor chip assembly 520A, a second semiconductor chip assembly 520B, the first cooling unit 130A, the second cooling unit 130B, the first supporting component 140A, the second supporting component 140B, at least one first fixing component 150, at least one second fixing component 152, the first socket 160A, the second socket 160B, the first compression component 170A, the second compression component 170B, at least one first optical fiber connector 180A, at least one second optical fiber connector 180B, at least one first optical fiber 190A, at least one second optical fiber 190B and at least one third optical fiber 195.

The semiconductor device 500 includes the features similar to or the same as that of the semiconductor device 100, and at least one difference is that the first semiconductor chip assembly 520A and the second semiconductor chip assembly 520B are different from the first semiconductor chip assembly 120A and the second semiconductor chip assembly 120B respectively.

As illustrated in FIG. 9, the first semiconductor chip assembly 520A includes a first substrate 520A1, at least one first chip 120A2, at least one second chip 120A3, at least one first contact 120A4, at least one second contact 120A5 and at least one third contact 120A6. The first substrate 520A1 of the first semiconductor chip assembly 520A incudes at least one first contact 520A11 and at least one second contact 520A12, wherein the first contact 520A11 is connected with the second chips 120A3 through a second contact 520A5, and the second contact 520A12 is connected with the first chip 120A2 through a second contact 520A5. In the present embodiment, the second contact 520A5 may be cured at a room temperature. Similarly, the second semiconductor chip assembly 520B includes a second substrate 520B1, at least one first chip 120B2, at least one second chip 120B3, at least one first contact 120B4, at least one second contact 520B5 and at least one third contact 120B6. The second substrate 520B1 of the second semiconductor chip assembly 520B incudes at least one first contact 520B11 and at least one second contact 520B12, wherein the first contact 520B11 is connected with the second chips 120B3 through a second contact 520B5, and the second contact 520B12 is connected with the first chip 120B2 through a second contact 520B5. In the present embodiment, the second contact 520B5 may be cured at a room temperature.

In another embodiment, the first semiconductor chip assembly 120A of the semiconductor device 300 in FIG. 3B may be replaced by the first semiconductor chip assembly 520A, and/or the second semiconductor chip assembly 120B of the semiconductor device 300 may be replaced by the second semiconductor chip assembly 520B. In other embodiment, in each of the aforementioned semiconductor devices 100, 200, 300, 400 and 500, the optical fiber 195 may be replaced by the soft ribbon bus, and the optical fiber connectors 180A and 180B may be replaced by bus connectors.

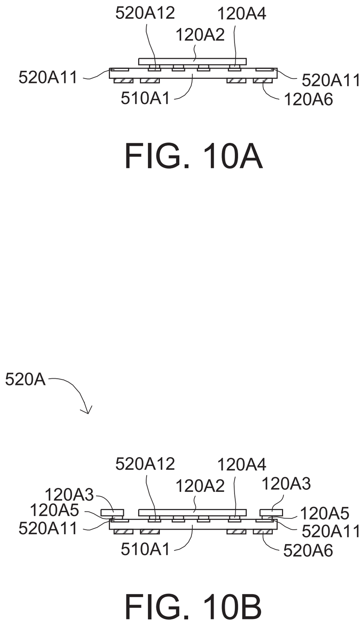

Referring to FIGS. 10A to 10B, FIGS. 10A to 10B illustrate schematic diagrams of manufacturing processes of the semiconductor device 500 in FIG. 9.

As illustrated in FIG. 10A, the first substrate 520A1 including at least one first contact 520A11 and at least one second contact 520A12 is provided, and at least one third contact 120A6 is disposed on a lower side of the first substrate 520A1, and the first chip 120A2 is disposed on an upper surface of the first substrate 520A1 through at least one first contact 120A4, wherein the first contact 120A4 is in contact with the second contact 520A12.

As illustrated in FIG. 10B, at least one second chip 120A3 is disposed on the upper surface of the first substrate 520A1 through at least one second contact 120A5 to form the first semiconductor chip assembly 520A, wherein the second contact 120A5 is in contact with the first contact 520A11. In the present embodiment, the second contact 120A5 is not required to be heated, and is combined with the first contact 520A11 at the room temperature.

The manufacturing method of the semiconductor device 500 further includes the steps the same as or similar to the corresponding steps of the semiconductor device 100, and it will not repeated here.

In another embodiment, the step of FIG. 7A of the semiconductor device 300 may be replaced by the steps of FIGS. 10A and 10B.

As described above, the semiconductor device includes at least circuit board, at least one semiconductor chip and at least one cooling unit. In an embodiment, the semiconductor chip is disposed between the cooling unit and the circuit board, wherein the semiconductor chip, the cooling unit and the circuit board are stacked in a thickness of the semiconductor device. As a result, it may reduce the area of the semiconductor device 100 in XY plane, and increase a manufacturing yield of the circuit board (due to the area of the circuit board may be reduced). In an embodiment, the semiconductor device may be disposed in a horizontal direction. In another embodiment, the semiconductor device may be disposed in a vertical direction. Furthermore, the circuit board of the semiconductor device may be inserted to a main board through a connector (for example, edge connector, etc.) in the vertical direction.

While the invention has been described in terms of what is presently considered to be the most practical and preferred embodiments, it is to be understood that the invention needs not be limited to the disclosed embodiment. On the contrary, it is intended to cover various modifications and similar arrangements included the appended claims which are to be accorded with the broadest interpretation so as to encompass all such modifications and similar structures.

## Claims

1. A semiconductor device (100, 200, 300, 400, 500), **characterized in that** the semiconductor device (100, 200, 300, 400, 500) comprises:
a first circuit board (110A, 210A, 310A, 410A) having a first surface (110Ab, 210Ab, 310Ab, 410Ab);
a first semiconductor chip assembly (120A, 220A, 520A) disposed on the first surface (110Ab, 210Ab, 310Ab, 410Ab) of the first circuit board (110A, 210A, 310A, 410A);
a first cooling unit (130A, 330A);
a first supporting component (140A, 340A, 440A) connecting the first cooling unit (130A, 330A) with the first circuit board (110A, 210A, 310A, 410A) in a thickness direction of the semiconductor device (100, 200, 300, 400, 500).

2. The semiconductor device (100, 200, 300, 400, 500) as claimed in claim 1, **characterized in that** the semiconductor device (100, 200, 300, 400, 500) further comprises:
a second cooling unit (130B);
a second supporting component (140B, 340B, 440B) connecting the second cooling unit (130B) with the first circuit board (110A, 210A, 310A, 410A) in the thickness direction of the semiconductor device (100, 200, 300, 400, 500);
wherein the first cooling unit (130A, 330A) and the second cooling unit (130B) are disposed on two opposite sides of the first supporting component (140A, 340A, 440A).

3. The semiconductor device (100, 200, 300, 400, 500) as claimed in claim 1 or 2, **characterized in that** the semiconductor device (100, 200, 300, 400, 500) further comprises:
a first socket (160A, 360A, 460A) disposed between the first circuit board (110A, 210A, 310A, 410A) and the first semiconductor chip assembly (120A, 220A, 520A);
wherein the first semiconductor chip assembly (120A, 220A, 520A) is electrically connected with the first circuit board (110A, 210A, 310A, 410A) through the first socket.

4. The semiconductor device (100, 200, 300, 400, 500) as claimed in claim 1, 2, or 3, **characterized in that** the semiconductor device (100, 200, 300, 400, 500) further comprises:
a first compression component (170A, 370A) pressing the first semiconductor **chip assembly** (120A, 220A, 520A) against the first circuit board (110A, 210A, 310A, 410A).

5. The semiconductor device (100, 200, 300, 400, 500) as claimed in any one of claims 1 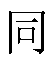 - to 4, **characterized in that** the first circuit board (110A, 210A, 310A, 410A) has a second surface (110Au, 210Au, 310Au, 410Au) opposite to the first surface (110Ab, 210Ab, 310Ab, 410Ab) of the first circuit board (110A, 210A, 310A, 410A), and the semiconductor device (100, 200, 300, 400, 500) further comprises:
a first optical fiber connector (180A) disposed on the first surface (110Ab, 210Ab, 310Ab, 410Ab) of the first circuit board (110A, 210A, 310A, 410A);
a second optical fiber connector (180B) disposed on the second surface (110Au, 210Au, 310Au, 410Au) of the first circuit board (110A, 210A, 310A, 410A);
a first optical fiber (190A) connecting the first optical fiber connector (180A) with the first semiconductor chip assembly (120A, 220A, 520A); and
a second optical fiber (190B) connecting the first optical fiber connector (180A) with the first semiconductor chip assembly (120A, 220A, 520A).

6. The semiconductor device (100, 200, 300, 400, 500) as claimed in any one of claims 1 to 5, **characterized in that** the first circuit board (110A, 210A, 310A, 410A) has a second surface (110Au, 210Au, 310Au, 410Au) opposite to the first surface (110Ab, 210Ab, 310Ab, 410Ab) of the first circuit board (110A, 210A, 310A, 410A), and the semiconductor device (100, 200, 300, 400, 500) further comprises:
a second circuit board (310B, 410B) has a first surface, wherein the first surface of the second circuit board (310B, 410B) faces the first surface (110Ab, 210Ab, 310Ab, 410Ab) of the first circuit board (110A, 210A, 310A, 410A); and
a second semiconductor chip assembly (120B, 220B, 520B) disposed on the first surface of the second circuit board (310B, 410B).

7. The semiconductor device (100, 200, 300, 400, 500) as claimed in claim 6, wherein **characterized in that** the first circuit board (110A, 210A, 310A, 410A) and the second circuit board (310B, 410B) are disposed on two opposite sides of the first circuit board (110A, 210A, 310A, 410A).

8. The semiconductor device (100, 200, 300, 400, 500) as claimed in claim 6 or 7, **characterized in that** the semiconductor device (100, 200, 300, 400, 500) further comprises:
a second supporting component (140B, 340B, 440B) connecting the second circuit board (310B, 410B) with the second cooling unit (130B) in the thickness direction of the semiconductor device (100, 200, 300, 400, 500);
wherein the first supporting component (140A, 340A, 440A) and the second supporting component (140B, 340B, 440B) are disposed on two opposite sides of the first cooling unit (130A, 330A).

9. The semiconductor device (100, 200, 300, 400, 500) as claimed in claim 6, 7 or 8, **characterized in that** the semiconductor device (100, 200, 300, 400, 500) further comprises:
a first socket (160A, 360A, 460A) disposed between the first circuit board (110A, 210A, 310A, 410A) and the first semiconductor chip assembly (120A, 220A, 520A);
wherein the first semiconductor chip assembly (120A, 220A, 520A) is electrically connected with the first circuit board (110A, 210A, 310A, 410A) through the first socket.

10. The semiconductor device (100, 200, 300, 400, 500) as claimed in claim 9, **characterized in that** the semiconductor device (100, 200, 300, 400, 500) further comprising:
a second socket (160B) disposed between the second circuit board (310B, 410B) and the second semiconductor chip assembly (120B, 220B, 520B);
wherein the second semiconductor chip assembly (120B, 220B, 520B) is electrically connected with the second circuit board (310B, 410B) through the second socket (160B).
